# EUROPEAN PATENT APPLICATION

(11) **EP 4 790 515 A1**
(43) Date of publication of application: **12.08.2026**
(21) Application number: 25747033.6
(22) Date of filing: 31.07.2025
(51) Int. Cl.: G06F 1/16, H05K 1/14, H05K 9/00

(54) **ELECTRONIC DEVICE INCLUDING PROTECTIVE FRAME**

(30) Priority: 13.08.2024 KR 20240108291; 19.09.2024 KR 20240126731
(71) Applicant: Samsung Electronics Co., Ltd, Suwon-si, Gyeonggi-do 16677 (KR)
(72) Inventor: JUNG, Soli, Suwon-si, Gyeonggi-do 16677 (KR); KIM, Jihoon, Suwon-si, Gyeonggi-do 16677 (KR); SONG, Minsuk, Suwon-si, Gyeonggi-do 16677 (KR); JUN, Jaeyoung, Suwon-si, Gyeonggi-do 16677 (KR); KIM, Minho, Suwon-si, Gyeonggi-do 16677 (KR); YOON, Byounguk, Suwon-si, Gyeonggi-do 16677 (KR); Lee, Jungwoo, Suwon-si, Gyeonggi-do 16677 (KR); Jung, Songhee, Suwon-si, Gyeonggi-do 16677 (KR); CHOI, Jinug, Suwon-si, Gyeonggi-do 16677 (KR)
(74) Representative: Gulde & Partner
(86) International application number: PCT/KR2025/011472
(87) International publication number: WO 2026/038768

(57) **Abstract**

According to various embodiments, an electronic device includes a first housing, a second housing rotatably coupled to the first housing through a hinge device, a flexible display being supported by the first housing and the second housing and including a bending portion, a first protective frame provided to the first housing, a second protective frame covering edges of the flexible display to not be visible from the outside and including a first area corresponding to the bending portion and a second area other than the first area, at least one conductive member provided on the inner surface of the second protective frame, corresponding to the first area, and at least one buffer member provided between the inner surface of the second protective frame and the flexible display and corresponding to the first area and the second area.

## Description

### Technical Field

Embodiments of the disclosure relate to an electronic device including a protective frame.

### Background Art

An electronic device is becoming increasingly slimmer, more rigid, more design-oriented, and, at the same time, more improved to differentiate its functional elements. The electronic device is gradually changing from a uniform rectangular shape to a variety of shapes. The electronic device may have a deformable structure that is convenient to carry and may utilize a large-screen display. For example, as part of a deformable structure, the electronic device may include a foldable housing structure that operates in a way of folding or unfolding with respect to each other. This electronic device may require a protective structure to protect a display and to protect internal electrical components from external static electricity.

The above-described information may be provided as the related art to help understanding of the disclosure. No claim or decision is made as to whether any of the above contents may be applied as the prior art related to the disclosure.

### Disclosure of Invention

### Technical Problem

A foldable electronic device may include a hinge device (e.g., hinge structure or hinge module) and at least two housings foldably connected to each other through the hinge device. This foldable electronic device may operate in an in-folding and/or out-folding manner by allowing a first housing to rotate with respect to a second housing with the range of 0 to 360 degrees through the hinge device. The foldable electronic device may include a flexible display provided to be at least partially supported through the first housing and the second housing in an unfolding state. The flexible display may be provided to be deformable (e.g., bendable or foldable) along with a folding and unfolding motion of the foldable electronic device.

The foldable electronic device may include a protective frame (e.g., protective cover, protective structure, protective decorative cover, or decorative member) provided to be supported by the first housing and the second housing, and to protect edges of the flexible display. The protective frame may be fixed to the first housing and/or the second housing and may cover the edges of the flexible display to not be visible from the outside. The foldable electronic device may include a buffer member (e.g., sponge) provided at a location at which at least a portion of the protective frame and the flexible display overlap when the surface of the flexible display is viewed from above. The buffer member may help reduce damage to the flexible display due to external impact and reduce the ingress of foreign substances.

Meanwhile, the flexible display may include a bending portion (e.g., chip on panel (COP)) that extends from a display panel and then bends toward the rear surface of the flexible display and includes control circuitry, at one lateral edge. For example, static electricity that flows in between the protective frame and the flexible display may flow in through the bending portion that is relatively close to the protective frame (electrostatic discharge (ESD)), which may cause damage to peripheral electrical components as well as the flexible display.

To prevent or reduce such damage and to induce static electricity introduced from the outside, the foldable electronic device may further include a conductive member provided between the protective frame and the flexible display.

However, the conductive member may hinder slimming of the electronic device by being provided to overlap the buffer member when the surface of the flexible display is viewed from above.

Various embodiments of the disclosure may provide an electronic device including a protective frame that may help slimming of the electronic device while including a smooth electrostatic induction structure.

According to various embodiments, there may be provided an electronic device including a protective frame that may help slimming of the electronic device while performing smooth buffering operation and sealing operation.

However, the subjects to be solved by the disclosure are not limited to the subjects described above and may be variously expanded without departing from the spirit and the scope of the disclosure.

### Solution to Problem

According to various embodiments, an electronic device may include a first housing; a second housing rotatably coupled to the first housing based on a folding axis through a hinge device; a flexible display provided to be supported through the first housing and the second housing, and including a bending portion that extends from at least a portion of a first edge parallel to the folding axis and folds toward the back surface of the flexible display; a first protective frame provided to the first housing to cover edges of the flexible display to not be visible from the outside; a second protective frame provided to the second housing to cover edges of the flexible display to not be visible from the outside, and including a first area corresponding to the bending portion and a second area other than the first area; at least one conductive member provided on the inner surface of the second protective frame, corresponding to the first area; and at least one buffer member provided between the inner surface of the second protective frame and the flexible display and corresponding to the first area and the second area, and in the first area, when the flexible display is viewed from above, the at least one conductive member and the at least one buffer member may be at least partially provided side by side, and between the second protective frame and the flexible display, static electricity introduced through the first edge may be induced to the at least one conductive member.

### Advantageous Effects of Invention

An electronic device according to exemplary embodiments of the disclosure may have a layout structure in which a conductive member for electrostatic induction and a buffer member for buffering and/or sealing are arranged side by side without overlapping between a protective frame provided to protect an edge corresponding to a bending portion (e.g., chip on panel (COP)) of a flexible display and the flexible display, which may lead to smooth electrostatic induction and induction of buffering and sealing operations, and at the same time, may help slimming of the electronic device.

In addition, various effects that may be directly or indirectly identified through this document may be provided.

The effects to be achieved by the disclosure are not limited to the above-described effects, and still other effects not mentioned herein will be clearly understood by one of ordinary skill in the art to which the disclosure pertains from the following description.

### Brief Description of Drawings

In relation to description of drawings, the same or like reference numerals may be used for the same or like components.
FIG. 1a illustrates the front surface of an electronic device in a flat state or an unfolding state according to various embodiments of the disclosure.
FIG. 1b illustrates the rear surface ofan electronic device in an unfolding state according to various embodiments of the disclosure.
FIG. 2a illustrates one side of an electronic device in a folding state according to various embodiments of the disclosure.
FIG. 2b illustrates the other side of an electronic device in a folding state according to various embodiments of the disclosure.
FIG. 3 is an exploded perspective view of an electronic device according to various embodiments of the disclosure.
FIG. 4 is an exploded perspective view of a flexible display according to various embodiments of the disclosure.
FIG. 5a is a top view of a flexible display according to various embodiments of the disclosure.
FIG. 5b is a rear view of a flexible display according to various embodiments of the disclosure.
FIG. 6a is a perspective view illustrating the layout structure of a flexible display and protective frames according to various embodiments of the disclosure.
FIG. 6b illustrates the layout structure of conductive members and buffer members according to various embodiments of the disclosure.
FIGS. 6c to 6e are partial perspective views illustrating an attachment structure in which conductive members and buffer members provided in a 6c area of FIG. 6b are attached to the inner surface of a protective frame according to various embodiments of the disclosure.
FIG. 6f illustrates a layout structure in which a conductive member and a buffer member viewed along the z-axis direction in the drawing of FIG. 6d are provided to a protective frame according to various embodiments of the disclosure.
FIG. 6g illustrates a layout structure in which a conductive member and a buffer member viewed along the -x-axis direction in the drawing of FIG. 6d are provided to a protective frame according to various embodiments of the disclosure.
FIG. 7a is a cross-sectional view of an electronic device viewed along line 7a-7a of FIG. 1a according to various embodiments of the disclosure.
FIG. 7b is a cross-sectional view of an electronic device viewed along line 7b-7b of FIG. 1a according to various embodiments of the disclosure.
FIG. 8 is a perspective view illustrating a layout structure in which a protective frame and a conductive member are provided to an electronic device according to various embodiments of the disclosure.
FIG. 9 illustrates the alignment structure of conductive members and buffer members through jigs according to various embodiments of the disclosure.
FIGS. 10a to 10f illustrate the layout structure of a conductive member and a buffer member according to various embodiments of the disclosure.
FIGS. 11a to 11f illustrate the layout structure of a conductive member and a buffer member according to various embodiments of the disclosure.
FIGS. 12a and 12b are cross-sectional views of an electronic device including a conductive member and a buffer member according to various embodiments of the disclosure.
FIG. 13 illustrates the layout structure in which conductive members and buffer members are provided to a flexible display according to various embodiments of the disclosure.
FIG. 14a is a front perspective view of a multi-foldable electronic device in an unfolding state according to various embodiments of the disclosure.
FIG. 14b is a rear perspective view of a multi-foldable electronic device in an unfolding state according to various embodiments of the disclosure.
FIG. 14c illustrates one surface of a multi-foldable electronic device in a folding state according to various embodiments of the disclosure.
FIG. 15a is a top view of an electronic device in a slide-out state according to various embodiments of the disclosure.
FIG. 15b is a cross-sectional view of an electronic device viewed along line 15b-15b of FIG. 15a according to various embodiments of the disclosure.
FIG. 15c is a cross-sectional view of an electronic device viewed along line 15c-15c of FIG. 15a according to various embodiments of the disclosure.

### Mode for the Invention

Hereinafter, with reference to the drawings, various example embodiments of the disclosure will be described in greater detail. However, the disclosure may be implemented in various different forms and is not limited to the example embodiments described herein. In connection with the description of the drawings, the same or similar reference symbols may be used for identical or similar components. Additionally, in the drawings and related descriptions, descriptions of well-known functions and configurations may be omitted for clarity and brevity.

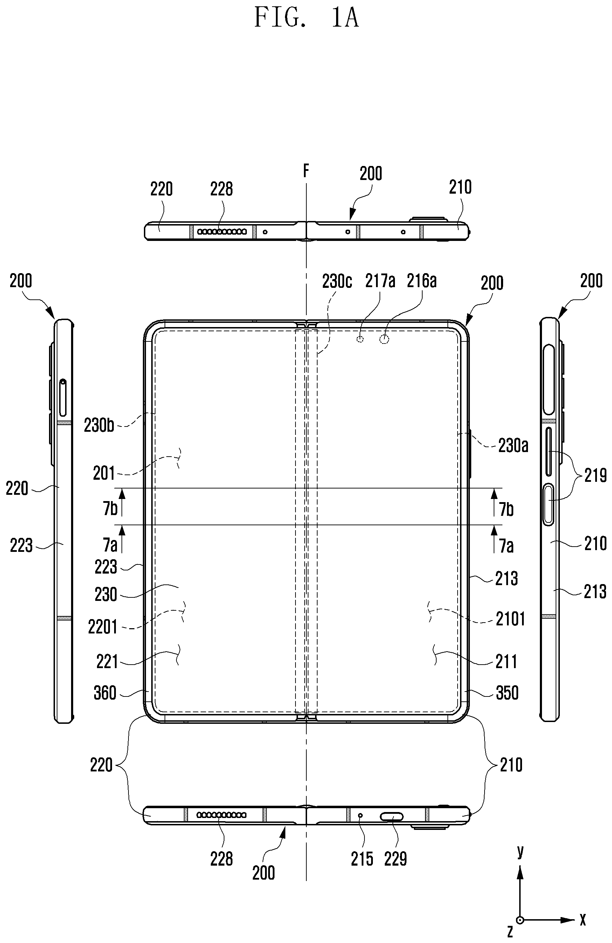

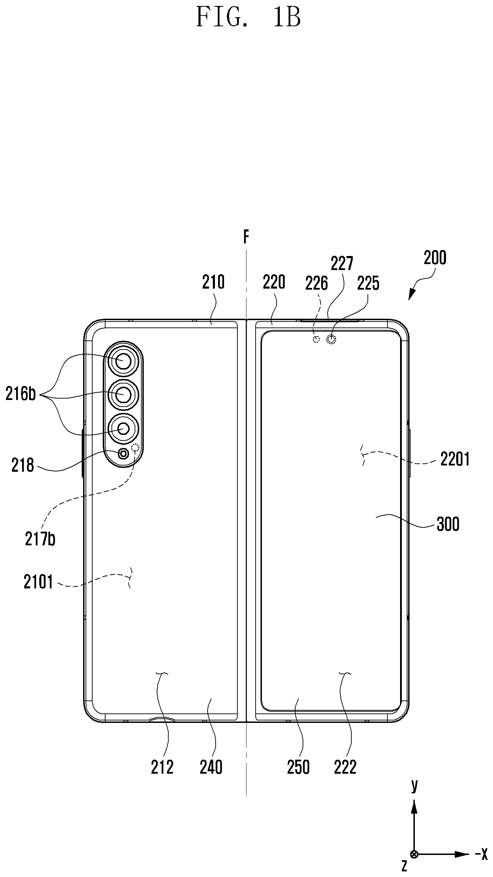

FIG. 1A is a diagram illustrating a front view of an electronic device in unfolded state according to various embodiments. FIG. 1B is a diagram illustrating a rear view of the electronic device in unfolded state according to various embodiments.

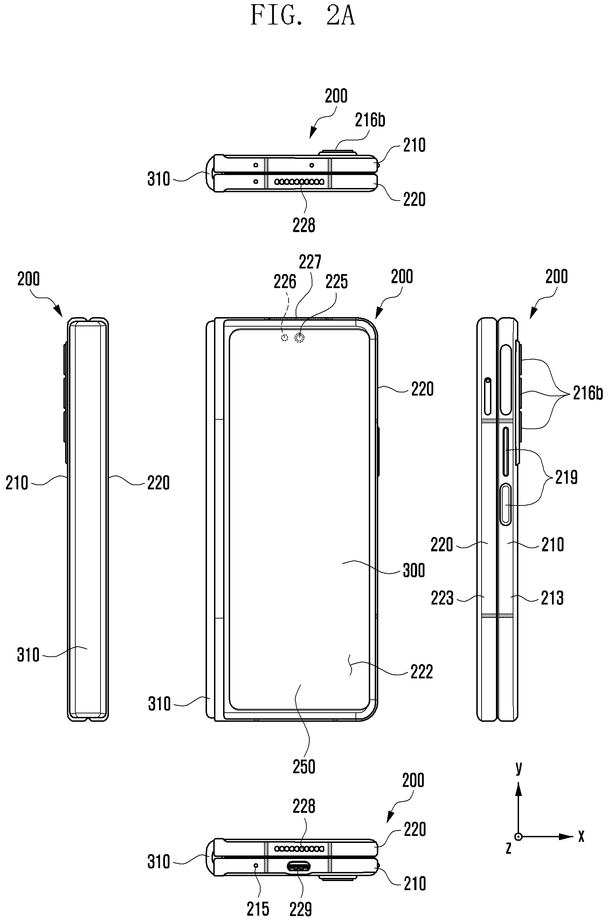

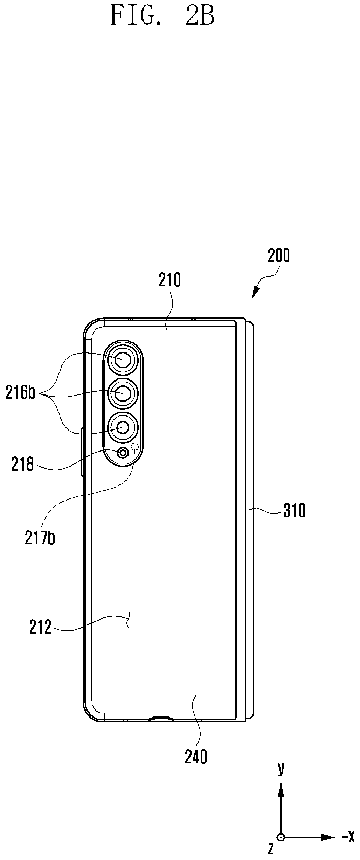

FIG. 2A is a diagram illustrating one side of the electronic device in folded state according to various embodiments. FIG. 2B is a diagram illustrating the other side of the electronic device in folded state according to various embodiments.

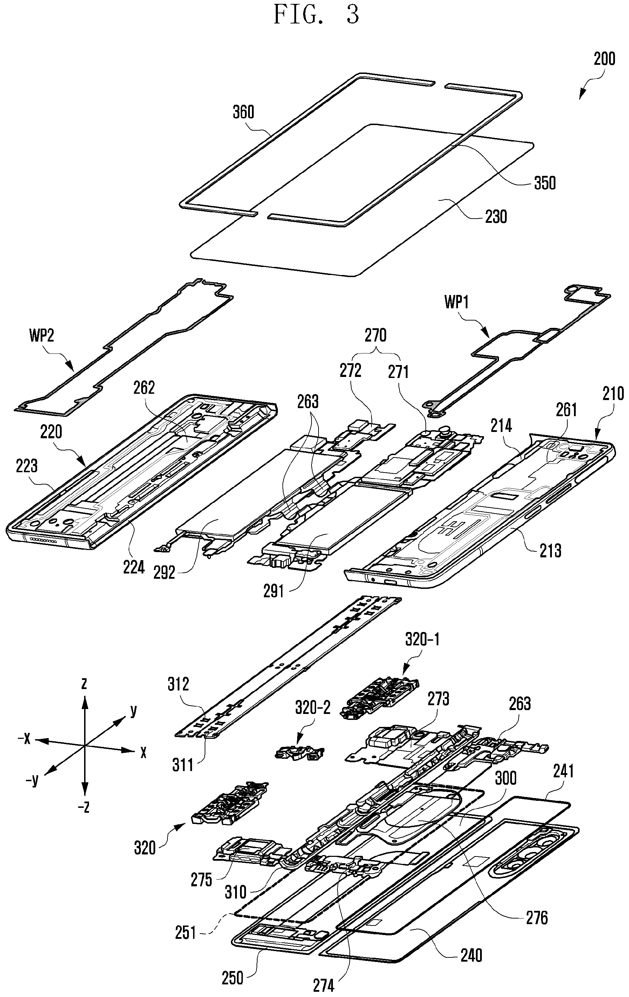

With reference to FIGS. 1A, 1B, 2A and 2B (which may be referred to as FIGS. 1A to 2B), the electronic device 200 may include a first housing 210 (e.g., first housing part or first housing structure) and a second housing 220 (e.g., second housing part or second housing structure) that are rotatably coupled to each other with respect to the folding axis (F) through at least one hinge device (e.g., hinge devices 320, 320-1 and 320-2 in FIG. 3) (e.g., hinge, hinge module, hinge structure, hinge unit, or hinge assembly). In an embodiment, the first housing 210 and the second housing 220 may be configured as the housing (e.g., foldable housing) of the electronic device 200. In an embodiment, the electronic device 200 may include a first display 230 (e.g., flexible display, foldable display, or main display) that is disposed to be accommodated or supported by the first housing and the second housing. In an embodiment, the electronic device 200 may include a second display 300 (e.g., sub-display) disposed through the second housing 220. In an embodiment, the electronic device 200 may include a hinge housing 310 (e.g., hinge cover), which is arranged so as to be at least partially invisible from the outside through the first housing 210 and the second housing 220 in the unfolded state, and cover the at least one hinge device (e.g., hinge devices 320, 320-1 and 320-2 in FIG. 3) so that it is not visible from the outside while in the folded state or while being folded. In the disclosure, the surface on which the first display 230 is disposed may be referred to as the front surface of the electronic device 200, and the opposite surface of the front surface may be referred to as the rear surface of the electronic device 200. Additionally, the surface surrounding the space between the front surface and the rear surface may be referred to as the side surface of the electronic device 200.

According to various embodiments, the first housing 210 and the second housing 220 may be arranged on both sides with respect to the folding axis (F), have a shape that is symmetrical overall with respect to the folding axis (F), and may be folded to match each other. In an embodiment, the first housing 210 and the second housing 220 may be folded asymmetrically with respect to the folding axis (F). In an embodiment, the angle or distance between the first housing 210 and the second housing 220 may be varied depending on whether the electronic device 200 is in the unfolded state, the folded state, or the intermediate state.

According to various embodiments, the first housing 210 may be rotatably connected to at least one hinge device (e.g., hinge devices 320, 320-1 and 320-2 in FIG. 3). In an embodiment, the first housing 210 may include, in the unfolded state, a first surface 211 disposed to face the front surface of the electronic device 200, a second surface 212 facing in the opposite direction of the first surface 211, and/or a first lateral member 213 surrounding at least a portion of a first space 2101 between the first surface 211 and the second surface 212.

According to various embodiments, the second housing 220 may be rotatably connected to at least one hinge device (e.g., hinge devices 320, 320-1 and 320-2 in FIG. 3). In an embodiment, the second housing 220 may include, in the unfolded state, a third surface 221 disposed to face the front surface of the electronic device 200, a fourth surface 222 facing in the opposite direction of the third surface 221, and/or a second lateral member 223 surrounding at least a portion of a second space 2201 between the third surface 221 and the fourth surface 222.

According to various embodiments, the first surface 211 may face substantially in the same direction as the third side 221 in the unfolded state, and may at least partially face the third side 221 in the folded state. In an embodiment, the electronic device 200 may include a recess 201 formed to accommodate the first display 230 through structural coupling between the first housing 210 and the second housing 220. In an embodiment, the recess 201 may have substantially the same size as the first display 230. In an embodiment, the first housing 210 may include a first protection frame 213a (e.g., first protection cover or first decorative member) that is coupled with the first lateral member 213 and is disposed to overlap the edge of the first display 230 when the first display 230 is viewed from above, thereby covering the edge of the first display 230 so that it is not visible from the outside. In an embodiment, the first protection frame 213a may be formed integrally with the first lateral member 213. In an embodiment, the second housing 220 may include a second protection frame 223a (e.g., second protection cover or first decorative member) that is coupled with the second lateral member 223 and is disposed to overlap the edge of the first display 230 when the first display 230 is viewed from above, thereby covering the edge of the first display 230 so that it is not visible from the outside. In an embodiment, the second protection frame 223a may be formed integrally with the second lateral member 223. In an embodiment, the first protection frame 213a and the second protection frame 223a may be omitted.

According to various embodiments, the hinge housing 310 (e.g., hinge cover) may be disposed between the first housing 210 and the second housing 220 so as to cover a portion of the at least one hinge device (e.g., hinge devices 320, 320-1 and 320-2 in FIG. 3). In an embodiment, the hinge housing 310 may be covered by a portion of the first housing 210 and the second housing 220 or exposed to the outside, depending on the unfolded state, the folded state, or the intermediate state of the electronic device 200. For example, when the electronic device 200 is in the unfolded state, the hinge housing 310 may be disposed to be substantially invisible from the outside due to at least a portion thereof being covered by the first housing 210 and the second housing 220. In an embodiment, when the electronic device 200 is in the folded state, the hinge housing 310 may be disposed so that at least a portion thereof is visible from the outside between the first housing 210 and the second housing 220. In an embodiment, in the intermediate state where the first housing 210 and the second housing 220 are folded with a certain angle, the hinge housing 310 may be disposed so as to be at least partially visible from the outside of the electronic device 200 between the first housing 210 and the second housing 220. For example, the area of the hinge housing 310 exposed to the outside may be less than compared with when in the fully folded state. In an embodiment, the hinge housing 310 may have an outer surface of curved, flat, or various shapes.

According to various embodiments, the electronic device 200 may include at least one of at least one display 230 and 300, input device (e.g., sound input device) 215, sound output devices 227 and 228, sensor modules 217a, 217b and 226, camera modules 216a, 216b and 225, key input device 219, indicator (not shown), or connector port 229, which is disposed in the first housing 210 and/or the second housing 220. In an embodiment, the electronic device 200 may additionally include at least one other component. In an embodiment, at least one of the components described above may be omitted.

According to various embodiments, the at least one display 230 and 300 may include a first display 230 (e.g., flexible display) that is disposed to be supported by the first surface 211 of the first housing 210 and the third surface 221 of the second housing 220, and a second display 300 that is disposed in the internal space of the second housing 220 so as to be at least partially visible from the outside through the fourth surface 222. In an embodiment, the second display 300 may be arranged in the first space 2101 of the first housing 210 so as to be visible from the outside through the second surface 212. In an embodiment, the first display 230 may be used primarily in the unfolded state of the electronic device 200, and the second display 300 may be used primarily in the folded state of the electronic device 200. In an embodiment, when in the intermediate state, the electronic device 200 may control the first display 230 and/or the second display 300 to be usable based on the folding angle between the first housing 210 and the second housing 220.

According to various embodiments, the first display 230 may be disposed in an accommodation space formed by the pair of housings 210 and 220. For example, the first display 230 may be disposed in the recess 201 formed by the pair of housings 210 and 220 so as to occupy substantially most of the front surface of the electronic device 200 in the unfolded state. In an embodiment, the first display 230 may include a flexible display whose at least a region may be changed into a flat or curved surface. In an embodiment, the first display 230 may include a first region 230a corresponding to the first housing 210 and a second region 230b corresponding to the second housing 220. In an embodiment, the first display 230 may include a folding region 230c (e.g., third region) that includes a portion of the first region 230a and a portion of the second region 230b with respect to the folding axis (F). In an embodiment, at least a portion of the folding region 230c may include a region that corresponds at least partially to the at least one hinge device (e.g., hinge devices 320, 320-1 and 320-2 in FIG. 3). In an embodiment, the regional division of the first display 230 is an illustrative demarcation made by the pair of housings 210 and 220 and the at least one hinge device (e.g., hinge devices 320, 320-1 and 320-2 in FIG. 3), and the first display 230 may display a single seamless full screen through the pair of housings 210 and 220 and the at least one hinge device (e.g., hinge devices 320, 320-1 and 320-2 in FIG. 3). In an embodiment, the first region 230a and the second region 230b may have an overall symmetrical shape or a partially asymmetrical shape with respect to the folding region 230c and/or the folding axis (F).

According to various embodiments, the electronic device 200 may include a first rear cover 240 disposed on the second surface 212 of the first housing 210, and a second rear cover 250 disposed on the fourth surface 222 of the second housing 220. In an embodiment, at least a portion of the first rear cover 240 may be formed integrally with the first lateral member 213. In an embodiment, at least a portion of the second rear cover 250 may be formed integrally with the second lateral member 223. In an embodiment, at least one of the first rear cover 240 or the second rear cover 250 may be made of a substantially transparent plate (e.g., glass plate including various coating layers, or polymer plate) or an opaque plate. In an embodiment, the first rear cover 240 may be made of an opaque plate, such as coated or colored glass, ceramic, polymer, metal (e.g., aluminum, stainless steel (STS), or magnesium), or a combination of at least two thereof. In an embodiment, the second rear cover 250 may be made of a substantially transparent plate such as glass or polymer. Hence, the second display 300 may be disposed in the second space 2201 of the second housing 220 so as to be visible from the outside through the second rear cover 250.

According to various embodiments, the input device 215 may include a microphone. In an embodiment, the input device 215 may include a plurality of microphones arranged to detect the direction of a sound. In an embodiment, the sound output devices 227 and 228 may include speakers. In an embodiment, the sound output devices 227 and 228 may include a call receiver 227 disposed through the fourth surface 222 of the second housing 220, and an external speaker 228 disposed through at least a portion of the second lateral member 223 of the second housing 220. In an embodiment, the input device 215, the sound output devices 227 and 228, and the connector 229 may be arranged in the spaces of the first housing 210 and/or the second housing 220, and may be exposed to the external environment through at least one hole formed in the first housing 210 and/or the second housing 220. In an embodiment, the holes formed in the first housing 210 and/or the second housing 220 may be used in common for the input device 215 and the sound output devices 227 and 228. In an embodiment, the sound output devices 227 and 228 may include a speaker (e.g., piezo speaker) that operates without the holes formed in the first housing 210 and/or the second housing 220.

According to various embodiments, the camera modules 216a, 216b and 225 may include a first camera module 216a disposed to photograph a subject through the first surface 211 of the first housing 210, a second camera module 216b disposed to be exposed through the second surface 212 of the first housing 210, and/or a third camera module 225 disposed to photograph a subject through the fourth surface 222 of the second housing 220. In an embodiment, the second camera module 261b may be disposed to photograph a subject through the third surface 221 of the second housing 220. In an embodiment, the electronic device 200 may include a flash 218 disposed close to the second camera module 216b. In an embodiment, the flash 218 may include, for example, a light emitting diode or a xenon lamp. In an embodiment, the camera modules 216a, 216b and 225 may include one or multiple lenses, an image sensor, and/or an image signal processor. In an embodiment, at least one of the camera modules 216a, 216b and 225 may include two or more lenses (e.g., wide-angle and telephoto lenses) and image sensors, and may be disposed together to photograph a subject through one surface of the first housing 210 and/or the second housing 220.

According to various embodiments, the sensor modules 217a, 217b and 226 may generate an electrical signal or data value corresponding to an internal operating state of the electronic device 200 or an external environmental state. In an embodiment, the sensor modules 217a, 217b and 226 may include a first sensor module 217a disposed to detect an external environment through the first surface 211 of the first housing 210, a second sensor module 217b disposed to detect an external environment through the second surface 212 of the first housing 210, and/or a third sensor module 226 disposed to detect an external environment through the fourth surface 222 of the second housing 220. In an embodiment, the sensor modules 217a, 217b and 226 may include at least one of a gesture sensor, a grip sensor, a color sensor, an infrared (IR) sensor, an illuminance sensor, an ultrasonic sensor, an iris recognition sensor, or a distance detection sensor (e.g., time of flight (TOF) sensor or light detection and ranging (LiDAR) sensor).

According to various embodiments, the electronic device 200 may further include at least one of sensor modules not shown, such as a pressure sensor, a magnetic sensor, a biometric sensor, a temperature sensor, a humidity sensor, or a fingerprint recognition sensor. In an embodiment, the fingerprint recognition sensor may be disposed through at least one lateral member among the first lateral member 213 of the first housing 210 and/or the second lateral member 223 of the second housing 220.

According to various embodiments, the key input devices 219 may be disposed to be exposed externally through the first lateral member 213 of the first housing 210. In an embodiment, the key input devices 219 may be disposed to be exposed externally through the second lateral member 223 of the second housing 220. In an embodiment, the electronic device 200 may not include some or all of the key input devices 219, and those key input devices 219 not included may be implemented in other forms, such as soft keys on at least one display 230 and 300. As an embodiment, the key input devices 219 may be implemented by utilizing a pressure sensor included in the at least one display 230 and 300.

According to various embodiments, the connector port 229 may include a connector (e.g., USB connector or interface connector port module (IF module)) for transmitting and receiving power and/or data to and from an external electronic device. In an embodiment, the connector port 229 may also perform a function for transmitting and receiving audio signals to and from the external electronic device, or may further include a separate connector port (e.g., ear jack hole) for performing a function for transmitting and receiving audio signals.

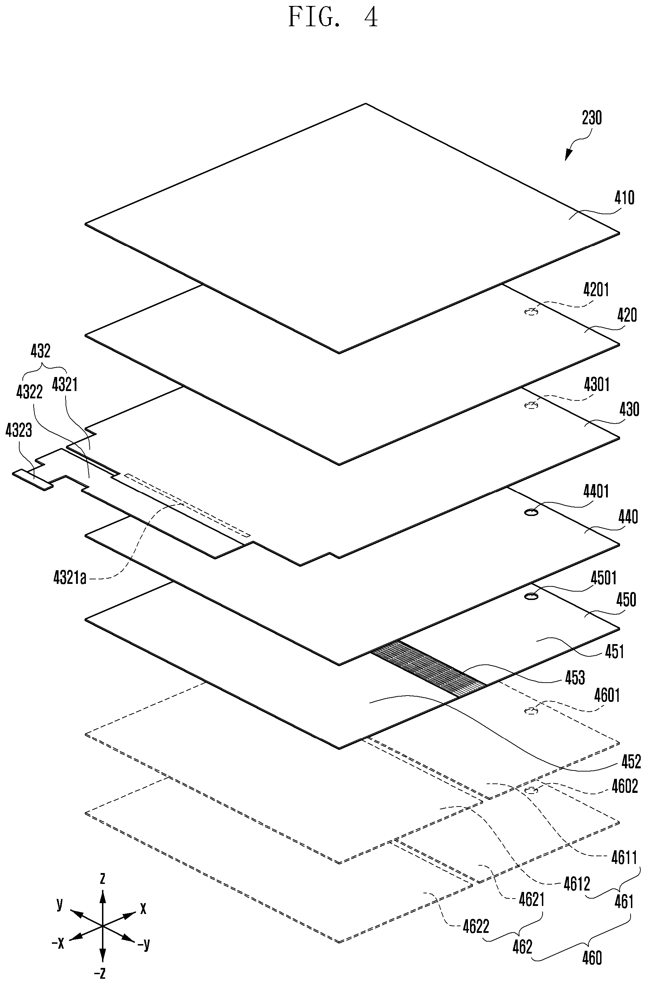

According to various embodiments, some camera modules 216a and 225, some sensor modules 217a and 226, and/or the indicator may be arranged to be visually exposed through the at least one display 230 and 300. For example, at least one camera module 216a and 225, at least one sensor module 217a and 226, and/or the indicator may be arranged below the active area (display area) of the at least one display 230 and 300 in the internal spaces of at least one housing 210 and 220 so as to come into contact with the external environment through a perforated opening or transparent region up to the cover member (e.g., window layer 410 in FIG. 4) and/or the second rear cover 250. In an embodiment, the area where at least one display 230 and 300 and at least one camera module 216a and 225 face may be formed as a transmissive region having a specific transmittance as part of the area displaying the content. In an embodiment, the transmissive region may be formed to have a transmittance in the range of about 5 percent to about 20 percent. This transmissive region may include a region overlapping with the effective area (e.g., field of view area) of at least one camera module 216a and 225 through which light passes to form an image through image formation of the image sensor. For example, the transmissive region of the at least one display 230 and 300 may include a region with a lower pixel density compared to the surrounding regions. For example, the transmissive region may replace the opening. For example, the at least one camera module 216a and 225 may include an under display camera (UDC) or an under panel camera (UPC). As an embodiment, some of the camera modules 216a and 225 or sensor modules 217a and 226 may be arranged so as to perform their functions without being visually exposed through the display. For example, the region facing the camera modules 216a and 225 and/or sensor modules 217a and 226 disposed under the displays 230 and 300 (e.g., display panel) may have an under display camera (UDC) structure, so that a perforated opening may be not necessary.

According to various embodiments, when the electronic device 200 is in the unfolded state (e.g., the state of FIG. 1A and FIG. 1B), the first housing 210 and the second housing 220 may make an angle of about 180 degrees, and the first region 230a, the second region 230b, and the folding region 230c of the first display 230 may be disposed to be on substantially the same plane and face in the same direction (e.g., z-axis direction). As an embodiment, when the electronic device 200 is in the unfolded state, the first housing 210 may be rotated at an angle of about 360 degrees with respect to the second housing 220 so that the second surface 212 and the fourth surface 222 face each other, folding in the opposite direction (out folding scheme).

According to various embodiments, when the electronic device 200 is in the folded state (e.g., the state of FIGS. 2A and 2B), the first surface 211 of the first housing 210 and the third surface 221 of the second housing 220 may be disposed to face each other. In this case, the first region 230a and the second region 230b of the first display 230 may be arranged to face each other through the folding region 230c while forming a narrow angle (e.g., in the range of 0 degrees to about 10 degrees). In an embodiment, at least a portion of the folding region 230c may be changed to a curved shape having a specific curvature. In an embodiment, when the electronic device 200 is in the intermediate state, the first housing 210 and the second housing 220 may be disposed to make a specific angle with respect to each other. In this case, the first region 230a and the second region 230b of the first display 230 may make an angle that is greater than that for the folded state and less than that for the unfolded state, and the curvature of the folding region 230c may be less than that for the folded state and greater than that for the unfolded state. In an embodiment, the first housing 210 and the second housing 220 may make an angle at which they can stop at a designated folding angle between the folded state and the unfolded state through at least one hinge device (e.g., hinge devices 320, 320-1 and 320-2 in FIG. 3) (free stop functionality). In an embodiment, the first housing 210 and the second housing 220 may be pressurized to maintain a state (free stop) or to continuously operate in the unfolding or folding direction with respect to a specified inflection angle through at least one hinge device (e.g., hinge devices 320, 320-1 and 320-2 in FIG. 3).

FIG. 3 is an exploded perspective view of an electronic device according to various embodiments of the disclosure.

With reference to FIG. 3, the electronic device 200 may include the first display 230 (e.g., flexible display), the second display 300, at least one hinge device 320, 320-1, 320-2, a pair of support members 261 and 262, at least one substrate 270 (e.g., printed circuit board (PCB)), the first housing 210, the second housing 220, the first rear cover 240, and/or the second rear cover 250.

According to various embodiments, the first display 230 may include the flexible display provided to be supported by the first support member 261 of the first housing 210 and the second support member 262 of the second housing 220. In an embodiment, the second display 300 may be provided in space between the second housing 220 and the second rear cover 250. In an embodiment, the second display 300 may be provided to be visible from the outside through substantially the entire area of the second rear cover 250 in the space between the second housing 220 and the second rear cover 250.

According to various embodiments, at least a portion of the first support member 261 may be foldably coupled to the second support member 262 through at least one hinge device 320, 320-1, 320-2. In an embodiment, the electronic device 200 may include at least one wiring member 263 (e.g., flexible printed circuit board (FPCB)) that is provided from at least a portion of the first support member 261 to a portion of the second support member 262 across the at least one hinge device 320, 320-1, 320-2. In an embodiment, the first support member 261 may be provided to extend from the first lateral member 213, or to be structurally coupled to the first lateral member 213. In an embodiment, the electronic device 200 may include a first space (e.g., first space 2101 of FIG. 1a) provided through the first support member 261 and the first rear cover 240. In an embodiment, the first housing 210 (e.g., first housing structure) may be configured through coupling of the first lateral member 213, the first support member 261, and the first rear cover 240. In an embodiment, the second support member 262 may be provided to extend from the second lateral member 223, or to be structurally coupled to the second lateral member 223. In an embodiment, the electronic device 200 may include a second space (e.g., second space 2201 of FIG. 1a) provided through the second support member 262 and the second rear cover 250. In an embodiment, the second housing 220 (e.g., second housing structure) may be configured through coupling of the second lateral member 223, the second support member 262, and the second rear cover 250. In an embodiment, at least a portion of the at least one wiring member 263 and/or the at least one hinge device 320, 320-1, 320-2 may be provided to be supported through at least a portion of a pair of support members 261 and 262. In an embodiment, the at least one wiring member 263 may be provided to extend from the first support member 261 to the second support member 262 across the folding axis (F). In an embodiment, the at least one wiring member 263 may be provided to have the length in a direction (e.g., x-axis direction) substantially perpendicular to the folding axis (e.g., y-axis or folding axis (F) of FIG. 1a).

According to various embodiments, at least one substrate 270 may include a first substrate 271 provided in the first space 2101 and a second substrate 272 provided in the second space 2201. In an embodiment, the first substrate 271 and the second substrate 272 may include a plurality of electronic components provided to implement various functions of the electronic device 200. In an embodiment, the first substrate 271 and the second substrate 272 may be electrically connected through the at least one wiring member 263.

According to various embodiments, the electronic device 200 may include at least one battery 291, 292. In an embodiment, the at least one battery 291, 292 may include the first battery 291 that is provided in the first space 2101 of the first housing 210 and electrically connected to the first substrate 271, and the second battery 292 that is provided in the second space 2201 of the second housing 220 and electrically connected to the second substrate 272. In an embodiment, the first support member 261 and/or the second support member 262 may further include at least one swelling hole for the first battery 291 and/or the second battery 292.

According to various embodiments, the first housing 210 may include a first rotational support surface 214, and the second housing 220 may include a second rotational support surface 224 corresponding to the first rotational support surface 214. In an embodiment, the first rotational support surface 214 and the second rotational support surface 224 may include the curved surface corresponding (naturally connected) to the curved outer surface of the hinge housing 310. In an embodiment, when the electronic device 200 is in an unfolding state, the first rotational support surface 214 and the second rotational support surface 224 may prevent the hinge housing 310 from being exposed to the rear surface of the electronic device 200 or may expose only a portion thereof by covering the hinge housing 310. In an embodiment, when the electronic device 200 is in a folding state, the first rotational support surface 214 and the second rotational support surface 224 may expose at least a portion of the hinge housing 310 to the rear surface of the electronic device 200 by rotating along the curved outer surface of the hinge housing 310.

According to various embodiments, the electronic device 200 may include at least one antenna member 276 provided in the first space 2101. In an embodiment, the at least one antenna member 276 may be provided to the first battery 291 and the first rear cover 240 in the first space 2101. In an embodiment, the at least one antenna member 276 may include, for example, a near field communication (NFC) antenna, a wireless charging antenna, and/or a magnetic secure transmission (MST) antenna. In an embodiment, the at least one antenna member 276 may, for example, perform near field communication with an external device or may wirelessly transmit and receive power required for charging. In some embodiments, an antenna structure may be formed by at least a portion of the first lateral member 213 or the second lateral member 223 and/or at least a portion of the first support member 261 and the second support member 262 or combination thereof.

According to various embodiments, the electronic device 200 may further include at least one electronic component assembly (274, 275) and/or additional support members 263 and 273 that are provided in the first space (e.g., first space 2101 of FIG. 1a) and/or the second space (e.g., second space 2201 of FIG. 1a). For example, at least one electronic component assembly (274, 275) may include the interface connector port assembly 274 or the speaker assembly 275.

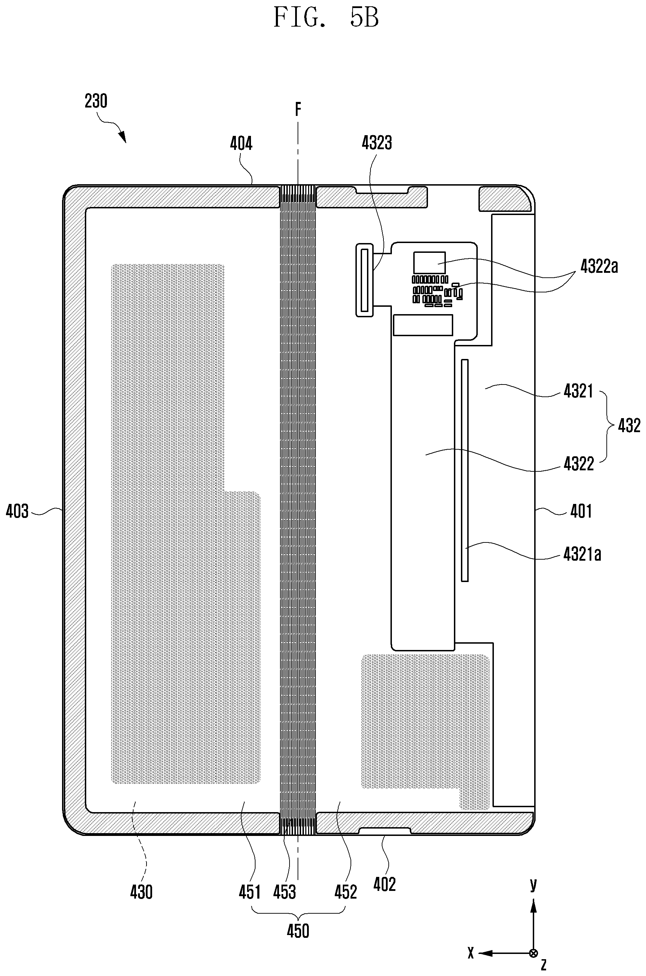

According to various embodiments, the electronic device 200 may include a first waterproof member (WP1) provided between the first display 230 and the first support member 261 and a second waterproof member (WP2) provided between the first display 230 and the second support member 262. In an embodiment, the first waterproof member (WP1) may provide at least one first waterproof space between the first display 230 and the first support member 261. In an embodiment, the at least one first waterproof space may accommodate at least one electronic component (e.g., camera module or sensor module) provided to be supported by the first support member 261. In an embodiment, the second waterproof member (WP2) may provide a second waterproof space between the first display 230 and the second support member 262. In an embodiment, the second waterproof space may accommodate at least a portion of the bending portion (e.g., bending portion 432 of FIG. 4) that folds toward the rear surface of the first display 230. For example, the second waterproof space may be provided to surround at least a portion of the bending portion (e.g., bending portion 432 of FIG. 4) that extends from the display panel 430 of the first display 230 and folds toward the back surface. Therefore, a control circuit (e.g., control circuit 4321a of FIG. 4) (e.g., display driver IC (DDI)) and a plurality of electrical elements (e.g., electrical elements 4322a of FIG. 5b) provided to the bending portion 432 may be provided in the second waterproof space, thereby being protected from external moisture and/or foreign substances.

According to various embodiments, the electronic device 200 may include a waterproof tape 241 provided between the first rear cover 240 and the first support member 261. In an embodiment, the electronic device 200 may include a bonding member 251 provided between the second rear cover 250 and the second support member 262. In some embodiments, the bonding member 251 may be provided between the second display 300 and the second housing 220. In some embodiments, the waterproof tape 241 may be replaced with the bonding member 251, and the bonding member 251 may be replaced with the waterproof tape 241.

According to various embodiments, the at least one hinge device 320, 320-1, 320-2 may include the first hinge device 320 provided at one end in a direction parallel to the folding axis (F) and the second hinge device 320-1 provided at the other end. In an embodiment, the first hinge device 320 and the second hinge device 320-1 may have substantially the same configuration. In an embodiment, the at least one hinge device 320, 320-1, 320-2 may include the connecting module 320-2 provided between the first hinge device 320 and the second hinge device 320-1. In an embodiment, the connecting module 320-2 may be provided through combination of one or more gears and/or at least one link combination. In some embodiments, the connecting module 320-2 may be replaced with the first hinge device 320.

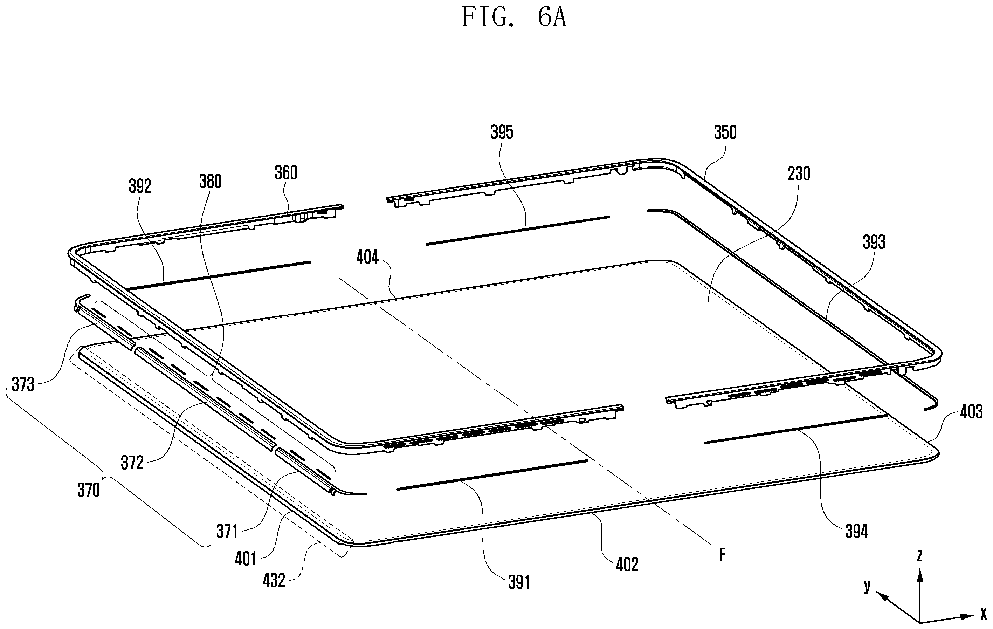

According to various embodiments, the electronic device 200 may include the first protective frame 350 provided along the border of the first housing 210 and covering edges (e.g., edges) of the first display 230 (e.g., flexible display) provided therebetween to not be visible from the outside. In an embodiment, the electronic device 200 may include the second protective frame 360 provided along the border of the second housing 220 and covering edges (e.g., edges) of the first display 230 provided therebetween to not be visible from the outside. In an embodiment, the electronic device 200 may include at least one conductive member (e.g., conductive member 370 of FIG. 6a) and at least one buffer member (e.g., buffer member 380 of FIG. 6a) provided on the inner surface of the second protective frame 360 corresponding to the bending portion (e.g., bending portion 432 of FIG. 4). In an embodiment, at least one conductive member 370 may induce static electricity introduced from the outside to the ground of the electronic device 200. In an embodiment, at least one buffer member 380 may reduce damage to the first display 230 due to external impact and/or may reduce the ingress of external foreign substances. In an embodiment, the at least one conductive member 370 and the at least one buffer member 380 may be provided side by side without overlapping on the inner surface of the second protective frame 360, thereby helping reduce the thickness of the electronic device 200 in the z-axis direction. In some embodiments, depending on a layout location of the bending portion 432, the at least one conductive member 370 and the at least one buffer member 380 may be provided on the inner surface of the first protective frame 350. In some embodiments, the layout structure of the at least one conductive member 370 and the at least one buffer member 380 may also be applied to a location corresponding to an edge of the first display 230 to which the bending portion 432 is not provided.

FIG. 4 is an exploded perspective view of a flexible display according to various embodiments of the disclosure.

The flexible display 230 of FIG. 4 may be at least partially similar to the first display 230 of FIG. 1A or may further include other embodiments of the flexible display.

The first display 230 according to exemplary embodiments of the disclosure may include an unbreakable (UB) type organic light-emitting diode (OLED) display (e.g., curved display). However, without being limited thereto, the first display 230 may also include an on cell touch active matrix organic light-emitting diode (AMOLED) (OCTA) type of a flat type display.

With reference to FIG. 4, the first display 230 (hereinafter, referred to as 'flexible display') may include a protective layer 410 (e.g., window layer), and a polarizing layer (polarizer (POL)) 420 (e.g., polarizing film), a display panel 430, a polymer layer 440, and a support plate 450 that are sequentially provided on the rear surface(e.g., -z-axis direction) of the protective layer 410. The display panel 430 is an inherent property of the first display 230 while each of the remaining protective layer 410, polarizing layer 420, polymer layer 440, and a support plate 450 may be selectively omitted. In an embodiment, the electronic device 200 may include at least one lower layer 460 additionally provided below the flexible display 230. The plurality of layers described above may be stacked in such a manner that they are attached to each other through an adhesive, for example, at least one of an optical clear adhesive (OCA), a pressure sensitive adhesive (PSA), a heat-reactive adhesive, a general adhesive, and a double-sided tape. In an embodiment, the lower layer 460 may include a digitizer 461 and/or a reinforcement plate 462. In an embodiment, the reinforcement plate 462 may include a first reinforcement plate 4621 provided at a location corresponding to a first housing (e.g., first housing 210 of FIG. 1a) and a second reinforcement plate 4622 provided at a location corresponding to a second housing (e.g., second housing 220 of FIG. 1a). In some embodiments, the reinforcement plate 462 may be integrally formed. In some embodiments, the flexible display 230 may include the digitizer 461 provided between the support plate 450 and the reinforcement plate 462. In some embodiments, the digitizer 461 may include a first digitizer 4611 provided at a location corresponding to the first housing (e.g., first housing 210 of FIG. 1a) and a second digitizer 4612 electrically connected to the first digitizer 4611 and provided at a location corresponding to the second housing (e.g., second housing 220 of FIG. 1a). In some embodiments, the digitizer 461 may be integrally formed. In some embodiments, the digitizer 461 may be provided between the polymer layer 440 and the support plate 450. In an embodiment, the digitizer 461 may include coil members provided on a dielectric substrate (e.g., dielectric film or dielectric sheet) to detect a resonant frequency of an electromagnetic induction method applied from an electronic pen. In some embodiments, when the flexible display 230 is a POL-less display, the polarizing layer 420 may be omitted and a transparent reinforcement layer (e.g., buffer layer) may be further provided at the location. In some embodiments, the polymer layer 440 and/or the reinforcement plate 462 may be omitted. In some embodiments, the polymer layer 440 may be further provided to the reinforcement plate 462. In some embodiments, the lower layer 460 may be omitted.

According to various embodiments, the protective layer 410 may have a multilayer structure in which layers are sequentially stacked on the display panel 430. In an embodiment, the protective layer may be formed of a glass layer and polymer (e.g., polyethylene terephthalate (PET), polyimide (PI), or thermoplastic polyurethane (TPU)) stacked on the glass layer. In some embodiments, the layers formed of polymer may be formed in three or more layers within the range of reference thickness allowed for the protective layer 410 of the flexible display. In an embodiment, a layer formed of polymer may include a coating layer. In an embodiment, the coating layer may include at least one of a hard coating (HC) layer, an anti-reflection (AR)/low-reflection (LR) coating layer, a shatter proof (SP) coating layer, and an anti-fingerprint (AF) coating layer.

According to various embodiments, the protective layer 410, the polarizing layer 420, the display panel 430, the polymer layer 440, and the support plate 450 may be provided to cross at least a portion of the first surface (e.g., first surface 211 of FIG. 1a) of the first housing (e.g., first housing 210 of FIG. 1a) and the third surface (e.g., third surface 221 of FIG. 1a) of the second housing (e.g., second housing 220 of FIG. 1a).

According to various embodiments, the display panel 430 may include a plurality of pixels and a wiring structure (e.g., electrode pattern). In an embodiment, the polarizing layer 420 may selectively allow light generated from a light source of the display panel 430 and vibrating in a certain direction to pass. In an embodiment, the display panel 430 and the polarizing layer 420 may be integrally formed. In an embodiment, the polarizing layer 420 may be deleted by providing a color filter formed of red (R), green (G), and blue (B) pigments having a polarizing function on pixels present on the display panel 430. In an embodiment, in the case of applying the color filter having the polarizing function, a light reflection blocking layer (e.g., black pixel define layer (BPDL)) capable of preventing reflection of external light may be included inside the display panel 430. In an embodiment, the flexible display 230 may include a touch panel (not shown).

According to various embodiments, the polymer layer 440 may be provided below the display panel 430 to provide the dark background for visibility securement of the display panel 430 and may be formed of a buffering material for buffering operation. In some embodiments, to waterproof the flexible display 230, the polymer layer 440 may be removed or may be provided below the support plate 450. In some embodiments, when the support plate 450 is formed of an opaque material, the polymer layer 440 may be omitted.

According to various embodiments, the support plate 450 may provide the bending property to the flexible display 230. For example, the support plate 450 may be formed of a non-metallic thin-plate material, such as fiber reinforced plastics (FRP) (e.g., carbon fiber reinforced plastics (CFRP) or glass fiber reinforced plastics (GFRP)) having rigid characteristics for supporting the display panel 430. In an embodiment, the support plate 450 may include a first flat portion 451 corresponding to the first housing (e.g., first housing 210 of FIG. 1a), a second flat portion 452 corresponding to the second housing (e.g., second housing 220 of FIG. 1a), and a flexible portion 453 (flexible portion or bending portion) that connects the first flat portion 451 and the second flat portion 452. In an embodiment, to improve flexibility, the flexible portion 453 may include a plurality of openings formed to penetrate from the top surface to the rear surface of the support plate 450 and/or a plurality of recess formed in a portion of the top surface and/or a portion of the back surface. In an embodiment, the bending property of the flexible portion 453 may be determined through at least one of size, shape, and layout density of at least a portion of the plurality of openings and/or at least a portion of the plurality of recesses. In some embodiments, the support plate 450 may be formed of a metal material, such as steel use stainless (SUS) (e.g., stainless steel (STS)), Cu, Al, or metal CLAD (e.g., stacked member in which SUS and Al are alternately stacked). In this case, the support plate 450 may have the plurality of openings formed over its entire area such that a detection operation of the digitizer 461 provided below is induced. In an embodiment, the support plate 450 may help reinforce the rigidity of the electronic device (e.g., electronic device 200 of FIG. 1a), may shield ambient noise, and may be used to dissipate heat emitted from surrounding heat-emitting components.

According to various embodiments, the flexible display 230 may include at least one auxiliary material layer (not shown) between the polymer layer 440 and the support plate 450, or below the support plate 450. In an embodiment, the at least one auxiliary material layer may include a graphite sheet for heat dissipation, a force-touch FPCB, a fingerprint sensor FPCB, an antenna radiator for communication, or a conductive/non-conductive tape. In an embodiment, the at least one auxiliary material layer may be replaced with the lower layer 460 that includes the digitizer 461 and/or the reinforcement plate 462 described above. In an embodiment, when the at least one auxiliary material layer is not bendable, it may be individually provided to the first housing (e.g., first housing 210 of FIG. 1a) and the second housing (e.g., second housing 220 of FIG. 1a). In an embodiment, when the at least one auxiliary material layer is bendable, it may be integrally formed to be provided from the first housing (e.g., first housing 210 of FIG. 1a) to at least a portion of the second housing (e.g., second housing 220 of FIG. 1a) through the hinge device (e.g., hinge devices 320, 320-1, and 320-2 of FIG. 3).

According to various embodiments, the flexible display 230 may include the bending portion 432 provided in a way of folding from the display panel 430 to at least a partial area of the rear surface(e.g., -z-axis direction) of the flexible display 230. In an embodiment, the bending portion 432 may include an extending portion 4321 that extends from the display panel 430 and includes a control circuit 4321a, and a flexible substrate 4322 (e.g., flexible substrate or flexible printed circuit board (FPCB)) that is electrically connected to the extending portion 4321 and includes a plurality of electronic elements. In an embodiment, the control circuit 4321a may include a display driver IC (DDI) or a touch display driver IC (TDDI) provided to the extending portion 4321 having an electrical wiring structure. In an embodiment, the bending portion 432 may include a chip on panel or chip on plastic (COP) structure in which the control circuit 4321a is directly provided to the extending portion 4321. In some embodiments, the bending portion 432 may also provide a chip on film (COF) structure in which the control circuit 4321a is provided to a separate connecting film (not shown) that connects the extending portion 4321 and the flexible substrate 4322. In an embodiment, the flexible display 230 may include a plurality of electronic elements (e.g., electronic elements 4322a of FIG. 5B) provided to the flexible substrate 4322. In an embodiment, the plurality of electronic elements may include a passive element, such as a touch IC, a flash memory for display, an ESD prevention diode, a pressure sensor, a fingerprint sensor, or a decapsulator (DECAP). In an embodiment, the flexible display 230 may include a connector portion 4323 (e.g., FPCB connecting portion) that extends from the flexible substrate 4322, and is electrically connected to a substrate (e.g., second substrate 272 of FIG. 3) of the electronic device (e.g., electronic device 200 of FIG. 3). According to an embodiment, when the bending portion 432 is provided in an area that faces the first housing (e.g., first housing 210 of FIG.1a) in the flexible display 230, the FPCB connecting portion 4323 may be electrically connected to still another substrate (e.g., first substrate 271 of FIG. 3) of the electronic device (e.g., electronic device 200 of FIG. 3).

According to various embodiments, the flexible display 230 may include openings 4201, 4301, 4401, 4501, 4601, and 4602 that are provided to the layers 420, 430, 440, 450, and 460, respectively, and are perforated in an area corresponding to the electronic component (e.g., camera device) provided below. In some embodiments, the display panel 430 and/or the polarizing layer 420 may not require the perforated openings 4301 and 4201.

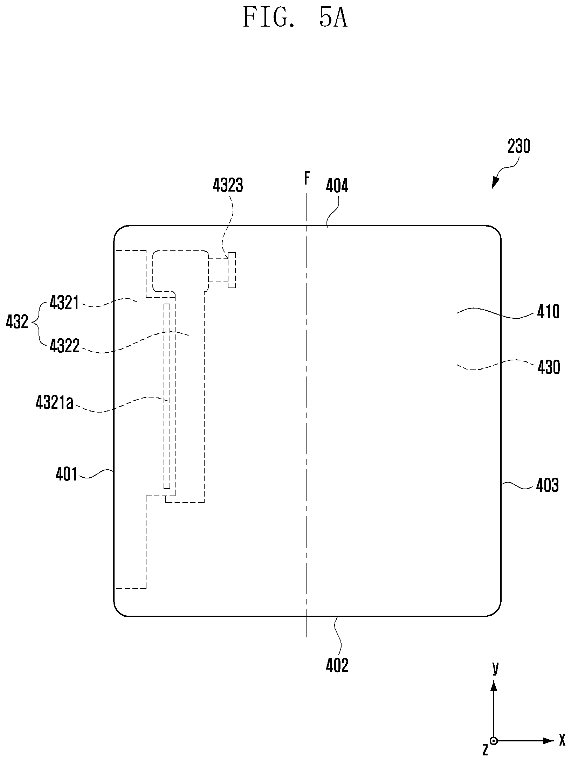

FIG. 5a is a top view of a flexible display according to various embodiments of the disclosure. FIG. 5b is a rear view of a flexible display according to various embodiments of the disclosure.

The flexible display 230 of FIGS. 5a and 5b may be substantially similar to the first display 230 of FIG. 1a, or may further include other embodiments of the flexible display.

With reference to FIGS. 5a and 5b, the flexible display 230 may include a first edge 401 having a first length, a second edge 402 extending from the first edge 401 in a perpendicular direction (e.g., x -axis direction), a third edge 403 extending from the second edge 402 in a direction parallel to the first edge 401 (e.g., y -axis direction) and having the first length, and a fourth edge 404 extending from the third edge 403 to the first edge 401 in a direction parallel to the second edge 402 (e.g., -x -axis direction) and having the second length. In an embodiment, the first edge 401 may be formed to have the length in a direction parallel to the folding axis (F). In an embodiment, the first length may be formed to be longer than the second length. In some embodiments, the first length may be formed to be equal to the second length or shorter than the second length.

According to various embodiments, the flexible display 230 may include the display panel 430 and the protective layer 410 stacked on the top surface of the display panel 430. In an embodiment, the flexible display 230 may include the bending portion 432 attached to the rear surface of the flexible display 230 in a way of extending and bending from the display panel 430 in the first edge 401. In an embodiment, the bending portion 432 may include the extending portion 4321, the flexible substrate 4322 that extends from the extending portion 4321, and the connector portion 4323 that extends from at least a portion of the flexible substrate 4322. In an embodiment, the flexible display 230 may include the control circuit 4321a provided to the extending portion 4321 and the plurality of electronic elements 4322a provided to the flexible substrate 4322.

According to various embodiments, the electronic device (e.g., electronic device 200 of FIG. 3) may include a second protective frame (e.g., second protective frame 360 of FIG. 3) that is provided to a second housing (e.g., second housing 220 of FIG. 3) to cover the first edge 401 of the flexible display 230 corresponding to the bending portion 432. In an embodiment, the electronic device 200 may include at least one conductive member (e.g., conductive member 370 of FIG. 6a) and at least one buffer member (e.g., buffer member 380 of FIG. 6a) that are provided on the inner surface of the second protective frame 360. In an embodiment, the at least one conductive member 370 may be provided on the inner surface of the second protective frame 360 in a first area corresponding to the bending portion 432. In an embodiment, the at least one buffer member 380 may be provided on the inner surface of the second protective frame 360 in the first area and a second area other than the first area (e.g., entire area). For example, in the first area, the at least one conductive member 370 and the at least one buffer member 380 may be provided together. For example, in the second area, only the at least one buffer member 380 may be provided. In an embodiment, the at least one conductive member 370 may induce static electricity introduced from the outside to the ground of the electronic device 200. In an embodiment, the at least one buffer member 380 may reduce damage to the first display 230 due to external impact and/or may reduce ingress of foreign substances. In an embodiment, the at least one conductive member 370 and the at least one buffer member 380 may be provided side by side without overlapping on the inner surface of the second protective frame 360, thereby helping reduce the thickness of the electronic device 200 in the z-axis direction. In some embodiments, the bending portion 432 may be provided to extend from one edge among the second edge 402, the third edge 403, and the fourth edge 404, other than the first edge 401. In this case, the at least one conductive member 370 and the at least one buffer member 380 may also be provided on the inner surface of a protective frame (e.g., first protective frame 350 or second protective frame 360) corresponding to the edge.

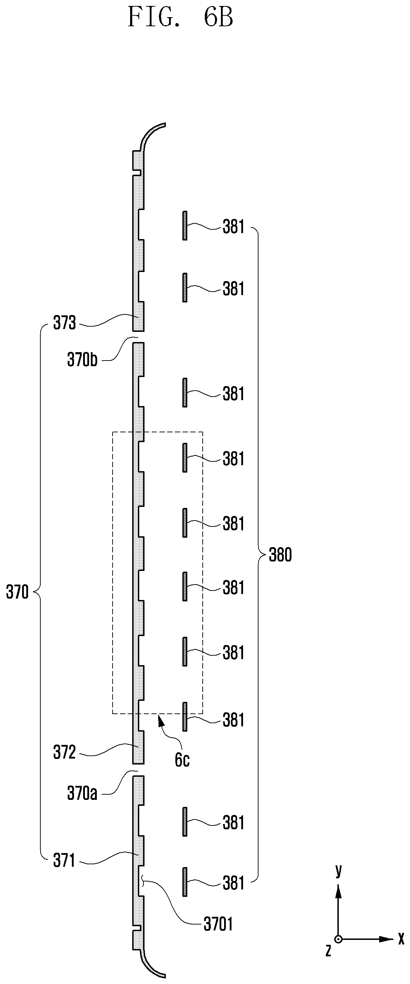

FIG. 6a is a perspective view illustrating the layout structure of a flexible display and protective frames according to various embodiments of the disclosure. FIG. 6b illustrates the layout structure of conductive members and buffer members according to various embodiments of the disclosure.

With reference to FIGS. 6a and 6b, the electronic device (e.g., electronic device 200 of FIG. 3) may include the flexible display 230 provided to be supported by the first housing (e.g., first housing 210 of FIG. 3) and the second housing (e.g., second housing 220 of FIG. 3). In an embodiment, the flexible display 230 may include the first edge 401 (e.g., first edge) positioned in a direction parallel to the folding axis (F), the second edge 402 (e.g., second edge) extending from the first edge 401 in a direction perpendicular to the folding axis (F), the third edge 403 (e.g., third edge) extending from the second edge 402 in a direction parallel to the first edge 401, and the fourth edge 404 (e.g., fourth edge) extending from the third edge 403 to the first edge 401. In an embodiment, the flexible display 230 may include the bending portion (e.g., bending portion 432 of FIG. 4) that extends from the display panel (e.g., display panel 430 of FIG. 4) and folds toward the rear surface of the flexible display 230 beyond the first edge 401.

According to various embodiments, the electronic device (e.g., electronic device 200 of FIG. 3) may include the first protective frame 350 provided along the border of the first housing 210 and covering edges (e.g., portion of second edge 402, third edge 403, and portion of fourth edge 404) of the flexible display 230 to not be visible from the outside, and the second protective frame 360 provided along the border of the second housing 220 and covering edges (e.g., first edge 401, portion of second edge 402, and portion of fourth edge 404) of the flexible display 230 to not be visible from the outside. In an embodiment, the protective frames 350 and 360 may be formed of a non-conductive material. In an embodiment, the protective frames 350 and 360 may include an injection molded article.

According to various embodiments, the electronic device (e.g., electronic device 200 of FIG. 3) may include at least one conductive member 370 at least partially provided between the second protective frame 360 and the flexible display 230, in an area corresponding to the first edge 401 to which the bending portion (e.g., bending portion 432 of FIG. 4) is provided. In an embodiment, the electronic device (e.g., electronic device 200 of FIG. 3) may include at least one buffer member 380 provided between the flexible display 230 and the protective frames 350 and 360. In an embodiment, the at least one conductive member 370 may include a conductive plate or a conductive film attached to the inner surface of the second protective frame 360. In some embodiments, the at least one conductive member 370 may be replaced with a conductive paint applied to the inner surface of the second protective frame 360. In an embodiment, the at least one buffer member 380 may include an elastic material. For example, the at least one buffer member 380 may include at least one of sponge, rubber, urethane, and silicone, and may be attached to the inner surface of the first protective frame 350 and the inner surface of the second protective frame 360 through an adhesive member (e.g., adhesive or double-sided tape). In an embodiment, the at least one conductive member 370 may be attached to the inner surface of the second protective frame 360 through the same or similar adhesive member. In an embodiment, since static electricity introduced from the electronic device 200 is highly likely to flow in the bending portion 432 that extends outward from the first edge 401 of the flexible display 230, the at least one conductive member 370 may be attached to the inner surface of the second protective frame 360 along the first edge 401 for electrostatic induction. However, without being limited thereto, the at least one conductive member 370 may be provided on the inner surface of the second protective frame 360 and the inner surface of the first protective frame 350 corresponding to the second edge 402, the third edge 403, and the fourth edge 404.

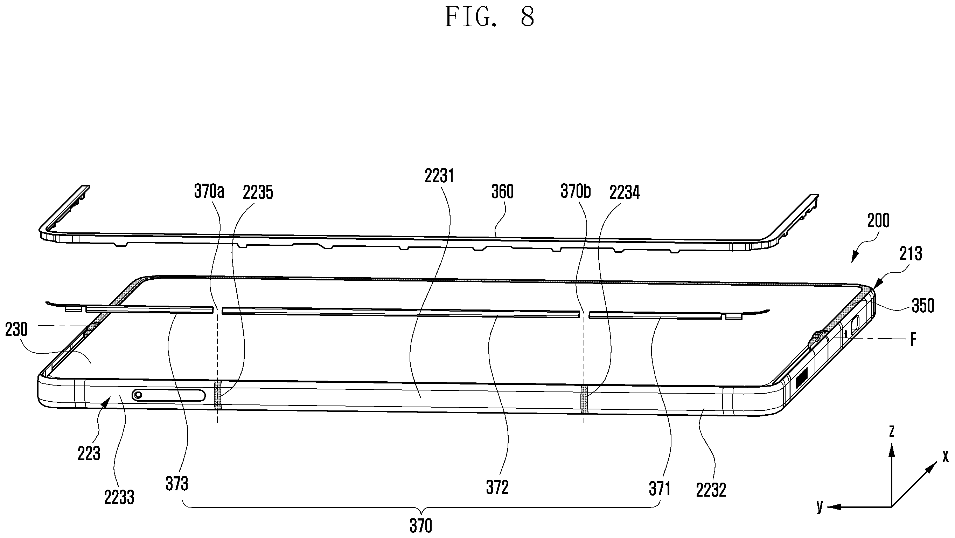

According to various embodiments, the at least one conductive member 370 may include a plurality of conductive members 371, 372, and 373 provided in a way of being separated along the first edge 401. For example, the at least one conductive member 370 may include the first conductive member 371, the second conductive member 372 spaced apart from the first conductive member 371 to have a first separation space 370a, and the third conductive member 373 spaced apart from the second conductive member 372 to have a second separation space 370b. In an embodiment, such separation spaces 370a and 370b are provided at locations at which when one or conductive portions (e.g., conductive portions 2231, 2232, and 2233 of FIG. 8) segmented by non-conductive portions (e.g., non-conductive portions 2234 and 2235 of FIG. 8) in a portion of a second lateral member (e.g., second lateral member 223 of FIG. 8) of the second housing (e.g., second housing 220 of FIG. 8) described below are used as antenna, they are aligned with the non-conductive portions 2234 and 2235, thereby reducing degradation of radiation performance of the antenna. In some embodiments, the at least one conductive member 370 may include four or more conductive members having one or three or more separation spaces along the first edge 401.

According to various embodiments, the at least one buffer member 380 may include a plurality of buffer members 381 provided side by side with the at least one conductive member 370 on the inner surface of the second protective frame 360. In an embodiment, each of the plurality of buffer members 381 may be provided in a way of being at least partially accommodated in the plurality of openings 3701 (e.g., recess, depression, or notch) spaced apart from each other along the longitudinal direction of the at least one conductive member 370 (e.g., along first edge 401). In an embodiment, each of the plurality of openings 3701 may have a shape that is recessed more inwardly than the boarder of the at least one conductive member 370. For example, when the flexible display 230 is viewed from above (e.g., when top surface of flexible display 230 is viewed from above), the at least one conductive member 370 and the at least one buffer member 380 may be provided side by side without overlapping each other. In an embodiment, when the flexible display 230 is viewed from above, the at least one conductive member 370 and the at least one buffer member 380 may be provided at a location that at least partially overlaps the first edge 401. In an embodiment, the parallel layout structure of the at least one conductive member 370 and the at least one buffer member 380 may help reduce the thickness of the electronic device 200 in the z -axis direction, and effective electrostatic induction through the at least one conductive member 370 and buffering and sealing operations through the at least one buffer member 380 may be induced. In some embodiments, each of the plurality of openings 3701 may have a different shape and/or size. In this case, the buffer members 381 accommodated in the plurality of openings 3701, respectively, and provided on the inner surface of the second protective frame 360 may be formed in shapes corresponding to the plurality of openings 3701, respectively. Further, the layout structure in which the buffer members 381 are at least partially accommodated in the openings 3701 of the conductive member 370 may help reduce the layout space in the widthwise direction (e.g., x-axis direction) while the conductive member 370 and the buffer members 381 are provided side by side.

In various embodiments, the electronic device 200 may include buffer members 391, 392, 393, 394, and 395 provided on the inner surface of the second protective frame 360 and the inner surface of the first protective frame 350 corresponding to the second edge 402 of the flexible display 230, the inner surface of the first protective frame 350 corresponding to the third edge 403 of the flexible display 230, and the inner surface of the second protective frame 360 and the inner surface of the first protective frame 350 corresponding to the fourth edge 404 of the flexible display 230. In an embodiment, such buffer members 391, 392, 393, 394, and 395 may be formed of substantially the same material as the at least one buffer member 380 provided at a location corresponding to the first edge 401 of the flexible display 230.

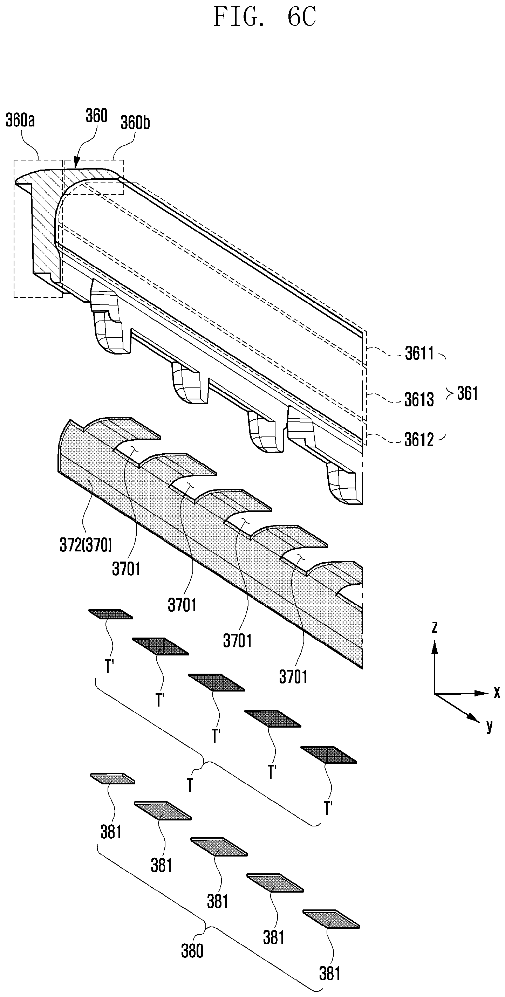

FIGS. 6c to 6e are partial perspective views illustrating an attachment structure in which conductive members and buffer members provided in a 6c area of FIG. 6b are attached to the inner surface of a protective frame according to various embodiments of the disclosure.

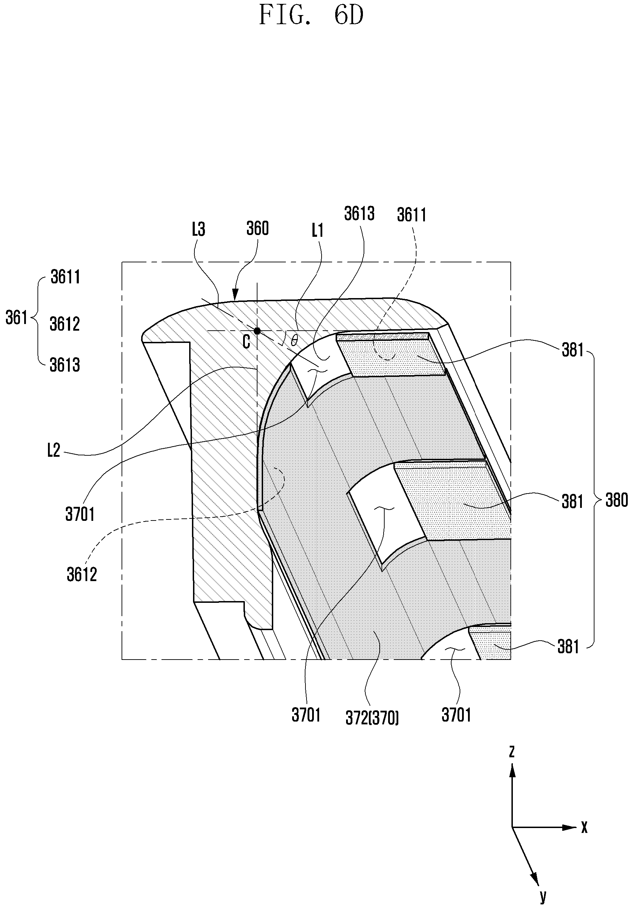

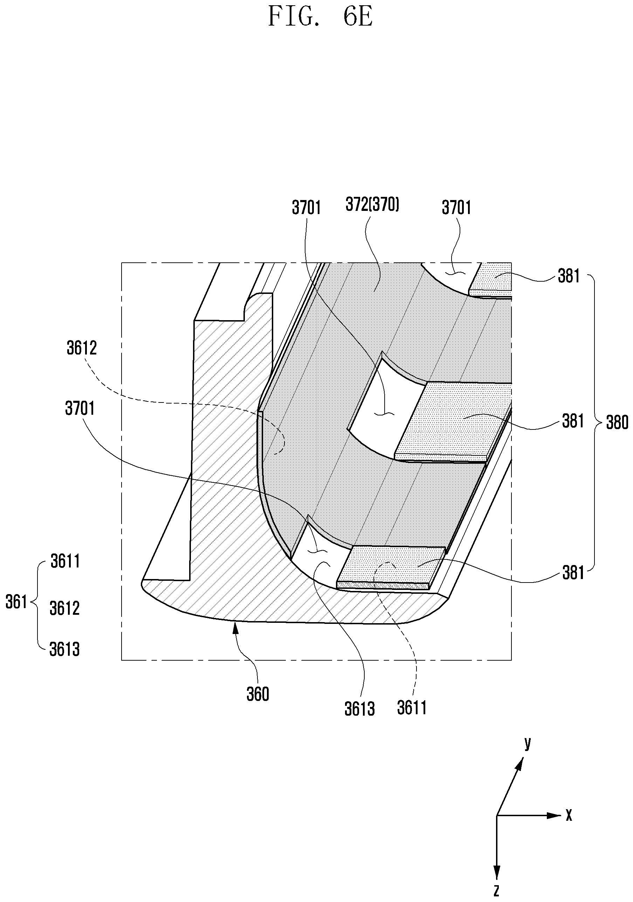

For example, FIG. 6c illustrates a state before the conductive member 370 and the buffer member 380 are attached to the inner surface 361 of the second protective frame 360. For example, FIGS. 6d and 6e illustrate a state in which the conductive member 370 and the buffer member 380 are attached side by side on the inner surface 361 of the second protective frame 360 in various directions.

With reference to FIGS. 6c to 6e, the second protective frame 360 may include a fixing portion 360a for fixing to the second housing 220 and a support portion 360b extending from the fixing portion 360a in a flexible display direction (e.g., x -axis direction). In an embodiment, the support portion 360b may be formed in a way of bending from the fixing portion 360a. In an embodiment, when the flexible display 230 is viewed from above, the inner surface 361 of the second protective frame 360 formed through the fixing portion 360a and the support portion 360b may include a first flat portion 3611 positioned to at least partially overlap the flexible display 230 in the support portion 360b and a second flat portion 3612 positioned in a direction perpendicular (e.g., z -axis direction) to the surface (e.g., top surface) of the flexible display 230 in the fixing portion 360a, and a curved portion 3613 that connects the first flat portion 3611 and the second flat portion 3612. In an embodiment, a portion of the curved portion 3613 may be included in at least a portion of the fixing portion 360a and the support portion 360b.

According to various embodiments, the conductive member 372 may be provided in a way of being attached to the inner surface 361 of the second protective frame 360. In this case, at least a portion of the conductive member 372 may be provided in a way of extending from at least a portion of the first flat portion 3611 of the second protective frame 360 to at least a portion of the second flat portion 3612 through the curved portion 3613. In an embodiment, the conductive member 372 may be provided such that at least a portion of each of the openings 3701 is positioned from at least a portion of the curved portion 3613 to at least a portion of the first flat portion 3611. For example, when the flexible display 230 is viewed from above, the conductive member 372 may be provided at a location at which at least a portion of each of the openings 3701 overlaps the flexible display 230.

According to various embodiments, the buffer members 381 may be provided in a way of being accommodated in the openings 3701 formed in the conductive member 372, respectively, and attached to the first flat portion 3611 through at least one tape member (T). In an embodiment, the at least one tape member (T) may include a plurality of tape members (T') to apply to the buffer members 381, respectively. In some embodiments, the buffer members 381 may be provided in a way of extending from the first flat portion 3611 to a portion of the curved portion 3613 in the openings 3701, respectively. In an embodiment, when the flexible display 230 is viewed from above, the buffer members 381 may be provided at a location that at least partially overlaps the flexible display 230. In an embodiment, the buffer members 381 may be provided in a way of contacting the top surface of the flexible display 230. In some embodiments, the buffer members 381 may be provided to be adjacent to the top surface of the flexible display 230 without contact therewith.

According to various embodiments, attachment locations of the buffer members 381 may be limited in the openings 3701. For example, if the buffer members 381 excessively extend from the first flat portion 3611 through the curved portion 3613, a separation distance from the bending portion 432 of the flexible display 230 becomes close and the bending portion 432 may be damaged by colliding with the buffer members 381 due to external impact such as dropping of the electronic device 200. Therefore, the greater the distance between the bending portion 432 and the curved portion 3613 the more advantageous, and the buffer members 381 may be attached to the curved portion 3613 within the range that satisfies this condition. For example, through a point (C) at which a first virtual line (L1) extending from the first flat portion 3611 and a second virtual line (L2) extending from the second flat portion 3612 meet and a corresponding angle (θ) when an angle formed by a third virtual line L3 passing the curved portion 3613 with the first virtual line L1 has the specific angle (θ), the buffer members 381 may extend from the first flat portion 3611 to a corresponding point of the curved portion 3613 that the third virtual line L3 passes. In an embodiment, the specific angle (θ) may be determined to be less than 60 degrees or less than 45 degrees. In an embodiment, through this layout structure of the buffer members 381, the gap between the curved portion 3613 and the bending portion 432 may be secured to the maximum extent, thereby helping reduce damage to the bending portion 432. In some embodiments, the buffer members 381 may be provided only to the first flat portion 3611 through the openings 3701 of the conductive member 372.

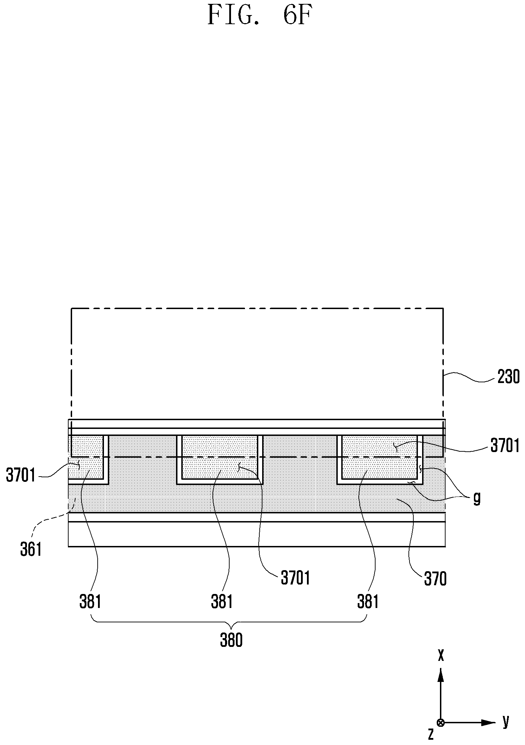

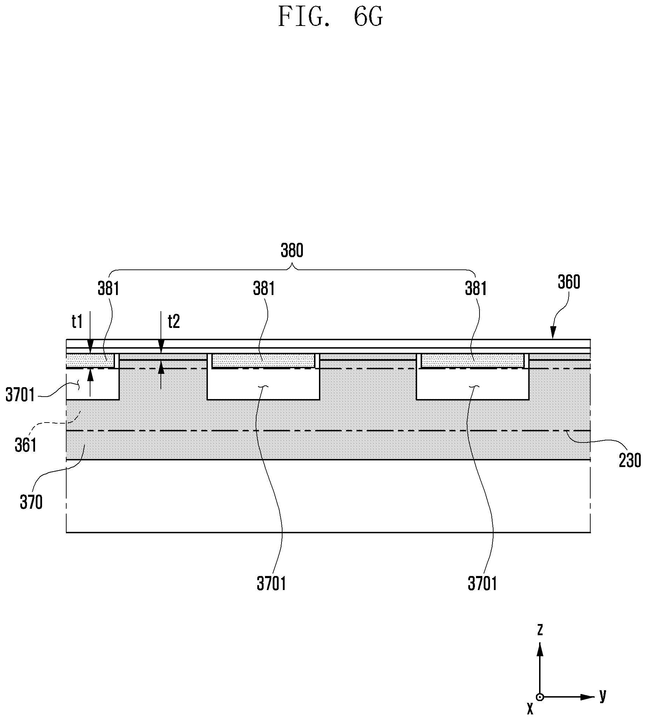

FIG. 6f illustrates a layout structure in which a conductive member and a buffer member viewed along the z-axis direction in the drawing of FIG. 6d are provided to a protective frame according to various embodiments of the disclosure. FIG. 6g illustrates a layout structure in which a conductive member and a buffer member viewed along the -x-axis direction in the drawing of FIG. 6d are provided to a protective frame according to various embodiments of the disclosure.

With reference to FIGS. 6f and 6g, the electronic device 200 may include at least one conductive member 370 and at least one buffer member 380 provided side by side on the inner surface 361 of the second protective frame 360. In an embodiment, the at least one conductive member 370 may include the openings 3701 spaced apart from each other. In an embodiment, the at least one buffer member 380 may include the buffer members 381 accommodated in the openings 3701, respectively, and directly attached to the inner surface 361 of the second protective frame 360. In an embodiment, the size (e.g., area) of the buffer members 381 may be formed smaller than the size (e.g., accommodation area) of the openings 3701 to have a specific gap (g) with the conductive member 370. Through this gap layout structure, when the buffer members 381 are initially attached to the inner surface 361 of the second protective frame 360 and then the conductive member 370 is attached, unintended overlapping layout (e.g., incorrect assembly) between the conductive member 370 and the buffer members 381 due to an assembly error may be reduced.

According to various embodiments, the first thickness (t1) of the buffer members 381 may be set to be greater than the second thickness (t2) of the conductive member 370. This is to smoothly perform the buffering operation by allowing the buffer members 381 to be attached to the inner surface 361 of the second protective frame 360 and to come into contact with the top surface of the flexible display 230. In some embodiments, the first thickness (t1) may also be set to be substantially equal to the second thickness (t2). In some embodiments, the plurality of buffer members 381 individually attached to the plurality of openings 3701, respectively, may be configured such that a single buffer member 381 and a neighboring buffer member 381 are connected to each other through a connecting portion having the thickness equal to at most the difference between the first thickness (t1) and the second thickness (t2). In this case, the connecting portion of the at least one buffer member 380 may be provided to overlap the conductive member 370 when the flexible display 230 is viewed from above.

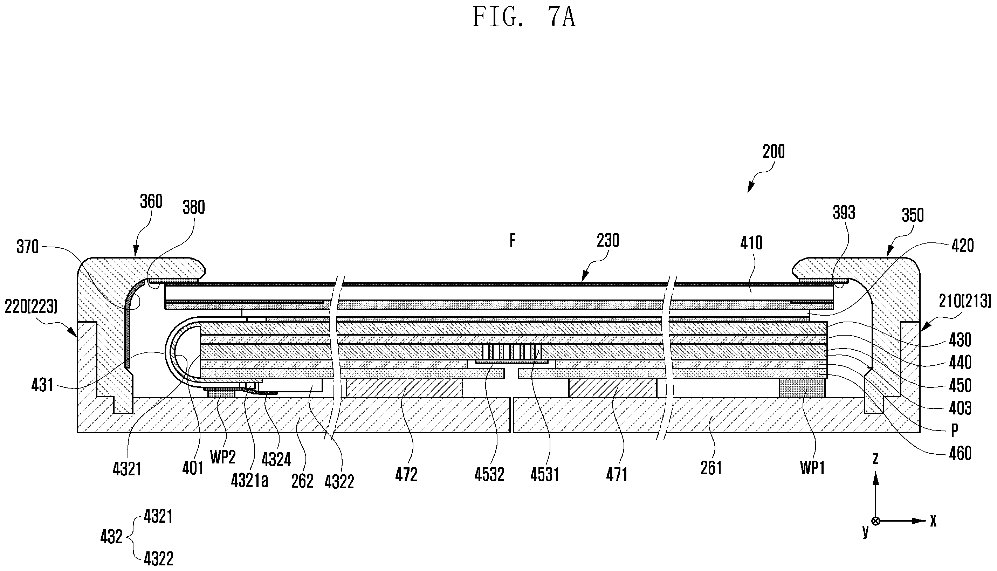

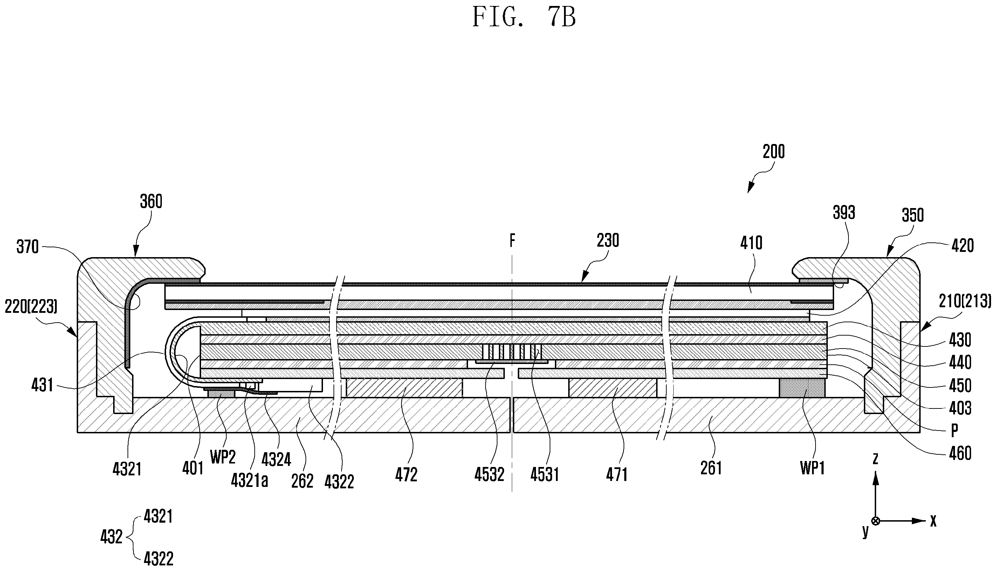

FIG. 7a is a cross-sectional view of an electronic device viewed along line 7a-7a of FIG. 1a according to various embodiments of the disclosure. FIG. 7b is a cross-sectional view of an electronic device viewed along line 7b-7b of FIG. 1a according to various embodiments of the disclosure.

For example, FIG. 7a is a cross-sectional view of the electronic device 200 illustrating a portion in which the conductive member 370 (e.g., conductive member 370 of FIG. 6b) and the buffer member 380 accommodated in the opening of the conductive member 370 (e.g., opening 3701 of FIG. 6b) are provided side by side on the inner surface of the second protective frame 360.

For example, FIG. 7b is a cross-sectional view of the electronic device 200 illustrating a state in which only the conductive member 370 (e.g., conductive member 370 of FIG. 6b) is provided in a portion in which the opening (e.g., opening 3701 of FIG. 6b) is absent.

With reference to FIGS. 7a and 7b, the electronic device 200 may include the first housing 210 that includes the first lateral member 213, the second housing 220 that includes the second lateral member 223 and is foldably connected to the first housing 210 through the hinge device (e.g., hinge device 320, 320-1, 320-2 of FIG. 3), and the flexible display 230 provided to be supported by the first housing 210 and the second housing 220.

According to various embodiments, the flexible display 230 may include the protective layer 410, and the display panel 430, the polymer layer 440, and the support plate 450 that are sequentially provided below the protective layer 410. In an embodiment, the support plate 450 may include a pattern 4531 that includes a plurality of openings formed at specified intervals in a folding area (e.g., folding area 230c of FIG. 1a) to provide the flexibility of the flexible display 230. In some embodiments, the pattern 4531 may also be replaced with a plurality of recesses formed lower than the outer surface. In some embodiments, the pattern 4531 may be configured in a form in which the plurality of openings and the plurality of recesses are mixed. In an embodiment, the flexible display 230 may include a blocking member 4532 provided in an area corresponding to the folding area 230c below the support plate 450 and provided to block the plurality of openings of the pattern 4531. According to an embodiment, the blocking member 4532 may include thermoplastic polyurethane (TPU) attached to the support plate 450. In an embodiment, the electronic device 200 may include the lower layer 460 provided below the flexible display 230. In this case, the lower layer 460 may be at least partially attached to the support plate 450 through an adhesive (P). In an embodiment, the lower layer 460 may include a digitizer (e.g., digitizer 461 of FIG. 4) and/or a reinforcement plate (e.g., reinforcement plate 462 of FIG. 4). In some embodiments, the lower layer 460 may be omitted.

According to various embodiments, the electronic device 200 may include at least one adhesive member 471, 472 provided between the flexible display 230 and the housings 210 and 220. For example, the at least one adhesive member 471, 472 may include the first adhesive member 471 provided between the lower layer 460 and the first housing 210 and the second adhesive member 472 provided between the lower layer 460 and the second housing 220. In an embodiment, the electronic device 200 may further include at least one of graphite for heat dissipation, a buffer member (e.g., sponge) for buffering, a step compensation member for step compensation, and/or a waterproof member for waterproofing, provided in at least a partial area other than an area in which the first adhesive member 471 and the second adhesive member 472 are provided between the lower layer 460 and the first housing 210 and/or between the lower layer 460 and the second housing 220.

According to various embodiments, the flexible display 230 may include the bending portion 432 attached to the rear surface of the flexible display 230 in a way of extending and bending from the display panel 430 in the first edge 401. In an embodiment, the bending portion 432 may include the extending portion 4321 and the flexible substrate 4322 that extends from the extending portion 4321. In an embodiment, the flexible display 230 may include the control circuit 4321a provided to the extending portion 4321. In an embodiment, the control circuit 4321a may be provided in the sealed space formed by a cover tape 4324 attached to connect the bending portion 432 and the flexible substrate 4322, thereby being protected from external moisture and/or foreign substances. In an embodiment, the bending portion 432 may further include a bending portion protective layer 431 that is stacked on the outer surface to protect the bending portion 432.

According to various embodiments, the electronic device 200 may include the first protective frame 350 provided to the first housing 210 and provided to at least partially cover the edge (e.g., third edge 403) of the flexible display 230 and the second protective frame 360 provided to the second housing 220 and provided to at least partially cover the edge (e.g., first edge 401) of the flexible display 230. In an embodiment, in the flexible display 230, not only the first edge 401 and the third edge 403 but also not shown second edge (e.g., second edge 402 of FIG. 6a) and fourth edge (e.g., fourth edge 404 of FIG. 6a) may be concealed to not be visible from the outside through the first protective frame 350 and the second protective frame 360.

According to various embodiments, the electronic device 200 may include the at least one conductive member 370 provided between the second protective frame 360 and the flexible display 230 and the at least one buffer member 380 provided side by side with the at least one conductive member 370 along the first edge 401. In an embodiment, the at least one conductive member 370 and the at least one buffer member 380 may be provided in a way of being attached to the inner surface of the second protective frame 360. In an embodiment, when the flexible display 230 is viewed from above, the at least one conductive member 370 and the at least one buffer member 380 may be provided to at least partially overlap the first edge 401. In an embodiment, the at least one buffer member 381 may be provided in a way of contacting the top surface of the flexible display 230. In an embodiment, the at least one conductive member 370 may be provided to be spaced apart from the flexible display 230. For example, the at least one conductive member 370 may be formed to be thinner than the thickness of the at least one buffer member 380 and accordingly, may not be in contact with the top surface of the flexible display 230. In some embodiments, the at least one conductive member 370 may be formed with the thickness substantially the same or thicker thickness than that of the at least one buffer member 380 and accordingly, may be in contact with the top surface of the flexible display 230. In an embodiment, the at least one conductive member 370 may help reduce damage to the flexible display 230 and surrounding electrical components by inducing static electricity introduced from the outside to the ground and/or conductive structure of the electronic device 200. In an embodiment, the at least one buffer member 380 may reduce damage to the flexible display 230 due to external impact such as dropping and/or may reduce ingress of foreign substances. In an embodiment, the at least one conductive member 370 and the at least one buffer member 380 (e.g., first buffer member) may be provided side by side without overlapping on the inner surface of the second protective frame 360, thereby helping reduce the thickness of the electronic device 200 in the z-axis direction. In an embodiment, the electronic device 200 may include still another buffer member 393 (e.g., second buffer member) provided between the first protective frame 350 and the flexible display 230. Still another buffer member 393 may be provided in a way of contacting the top surface of the flexible display 230 alone, without the conductive member 370.

FIG. 8 is a perspective view illustrating a layout structure in which a protective frame and a conductive member are provided to an electronic device according to various embodiments of the disclosure.

With reference to FIG. 8, the electronic device 200 may include at least one conductive member 370 provided between the second protective frame 360 and the flexible display 230 in an area of the first edge (e.g., first edge 401 of FIG. 6a) of the flexible display 230. In an embodiment, the at least one conductive member 370 may include a plurality of conductive members 371, 372, and 373 that are spaced apart from each other along the first edge 401 of the flexible display 230. In an embodiment, the at least one conductive member 370 may include the first conductive member 371, the second conductive member 372 spaced apart from the first conductive member 371 to have the first separation space 370a, and the third conductive member 373 spaced apart from the second conductive member 372 to have the second separation space 370b.

According to various embodiments, the electronic device 200 may include conductive portions 2231, 2232, and 2233 provided through at least a portion of the second lateral member 223 formed of a conductive material (e.g., metal). In an embodiment, the conductive portions 2231, 2232, and 2233 may include the first conductive portion 2231 provided through the first non-conductive portion 2234 (e.g., first segment portion) and the second non-conductive portion 2235)(e.g., second segment portion) spaced apart from each other, the second conductive portion 2232 provided to face the first conductive portion 2231 based on the first non-conductive portion 2234, and the third conductive portion 2233 provided to face the first conductive portion 2231 based on the second non-conductive portion 2235. In an embodiment, at least one conductive portion among the first conductive portion 2231, the second conductive portion 2232, and/or the third conductive portion 2233 may operate as an antenna configured to transmit and/or receive a wireless signal in at least one specific frequency band.

According to various embodiments, the separation spaces 370a and 370b of the conductive portions 371, 372, and 373 may be aligned with the non-conductive portions 2234 and 2235 provided to the second lateral member 223. Through this alignment, the second conductive member 372 may be aligned with the first conductive portion 2231 and may have the same length. In an embodiment, alignment and arrangement between the separation spaces 370a and 370b of the conductive members 371, 372, and 373 and the non-conductive portions 2234 and 2235 of the second lateral member 223 may help reduce degradation in heat dissipation performance of the antenna that operates through the conductive portions 2231, 2232, and 2233.

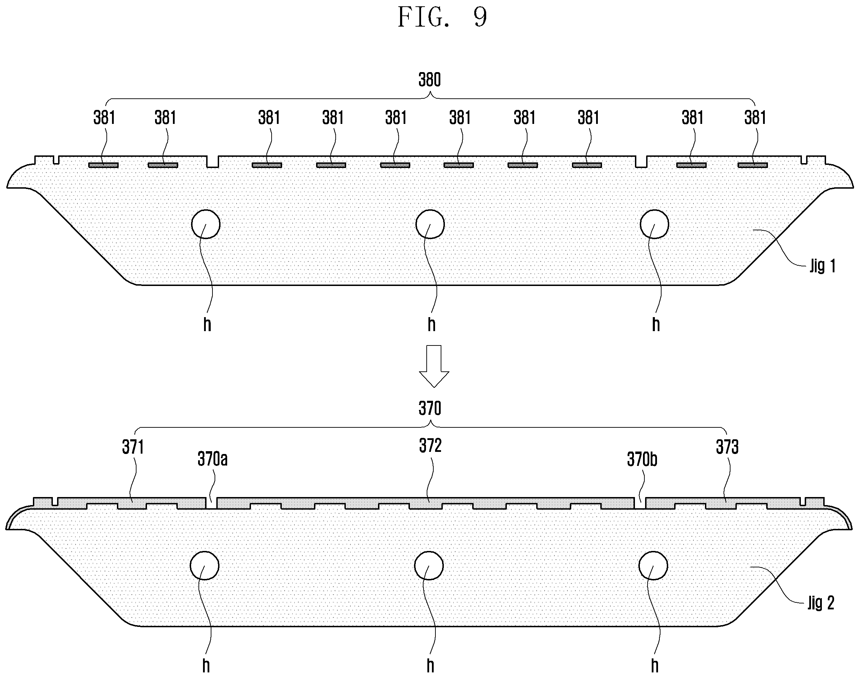

FIG. 9 illustrates the alignment structure of conductive members and buffer members through jigs according to various embodiments of the disclosure.

With reference to FIG. 9, in the inner surface (e.g., inner surface 361 of FIG. 6c) of the second protective frame (e.g., second protective frame 360 of FIG. 6c), at least one buffer member 380 may be initially attached through a first jig (Jig 1) and then at least one conductive member 370 may be attached through a second jig (Jig 2). For example, the at least one buffer member 380 has thicker thickness than that of the at least one conductive member 370, but is compressed due to its own elasticity. Therefore, although the at least one conductive member 370 is attached later, a compression force may be smoothly provided. However, when the at least one conductive member 370 is initially attached to the inner surface 361 of the second protective frame 360, the at least one buffer member 380 subsequently attached is hindered by the thickness of the at least one conductive member 370, so sufficient compression force may not be provided. In an embodiment, the first jig (Jig 1) and the second jig (Jig 2) may include alignment holes (h) for correct alignment between the at least one buffer member 380 and the at least one conductive member 370.

In some embodiments, when the plurality of buffer members 381 are not correctly aligned in the openings 3701 of the at least one conductive member 370, the at least one conductive member 370 and the at least one buffer member 380 may require a constitution for identifying this. For example, by configuring color of the inner surface 361 of the second protective frame 360, color of the at least one conductive member 370, and color of the at least one buffer member 380 to be different from one another, mis-attachment between the two members 370 and 380 may be easily identified with the naked eye. For example, when the inner surface 361 of the second protective frame 360 is formed with dark color, mis-attachment (e.g., overlapping attachment) between the two members 370 and 380 may be easily determined by configuring the color of the at least one buffer member 380 to be relatively bright or reflective and by configuring the color of the at least one conductive member 370 applied later to be relatively dark.

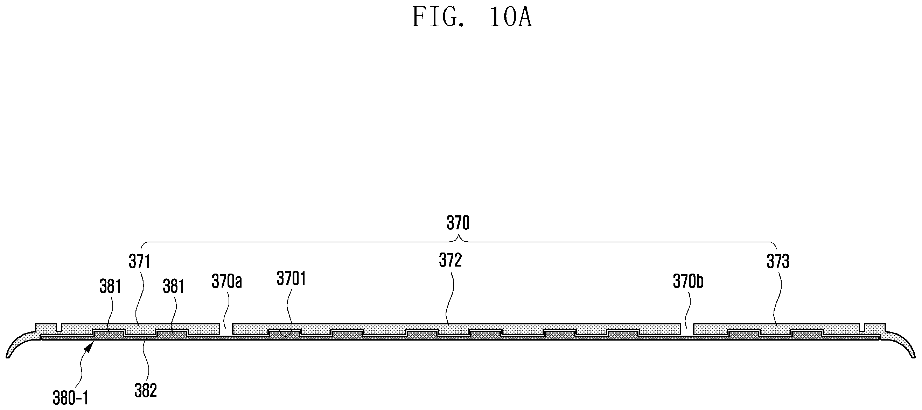

FIGS. 10a to 10f illustrate the layout structure of a conductive member and a buffer member according to various embodiments of the disclosure.

With reference to FIG. 10a, at least one conductive member 370 may include the first conductive member 371, the second conductive member 372, and the third conductive member 373 spaced apart from each other through the first separation space 370a and the second separation space 370b. In an embodiment, the at least one conductive member 370 may include the plurality of openings 3701 provided at specific intervals. In an embodiment, the plurality of openings 3701 may include a recess or a notch recessedmore inwardly than one boarder of the at least one conductive member 370.

According to various embodiments, at least one buffer member 380-1 may include a connecting portion 382 that extends in the longitudinal direction of the at least one conductive member 370 and protruding portions 381 that protrude from the connecting portion 382 at locations corresponding to the openings 3701, respectively. In an embodiment, the connecting portion 382 and the protruding portions 381 may be integrally formed. In an embodiment, the connecting portion 382 and the protruding portions 381 may be provided side by side without overlapping the at least one conductive member 370. In an embodiment, the protruding portions 381 may be provided in a way of being at least partially accommodated in the openings 3701, respectively. In an embodiment, the connecting portion 382 may be provided to the first flat portion 3611 on the inner surface 361 of the second protective frame 360 formed to have an area for accommodating interlayer slip of the flexible display 230 that occurs according to a folding and unfolding operation of the electronic device 200.

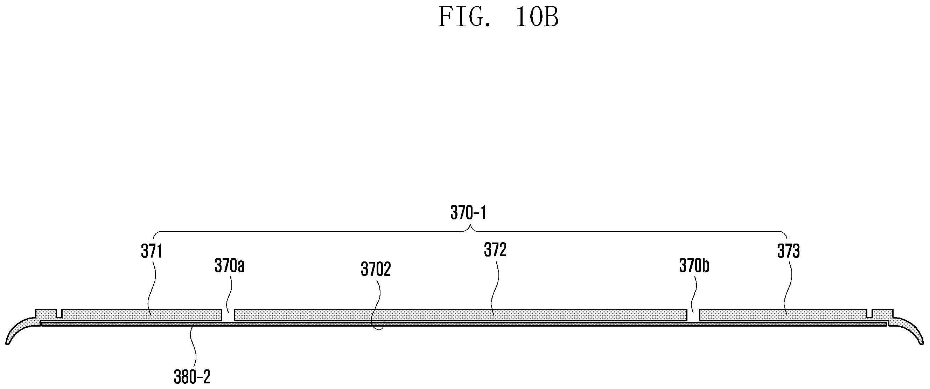

With reference to FIG. 10b, the at least one conductive member 370 may include the first conductive member 371, the second conductive member 372, and the third conductive member 373 segmented through the first separation space 370a and the second separation space 370b. In an embodiment, at least one conductive member 370-1 may include an opening 3702 consecutively formed from the border of the first conductive member 371, along the border of the third conductive member 373 across the second conductive member 372. In an embodiment, at least one buffer member 380-2 may include a single buffer member 380-2 accommodated in the opening 3702 formed from the first conductive member 371 to the third conductive member 373 through the second conductive member 372.

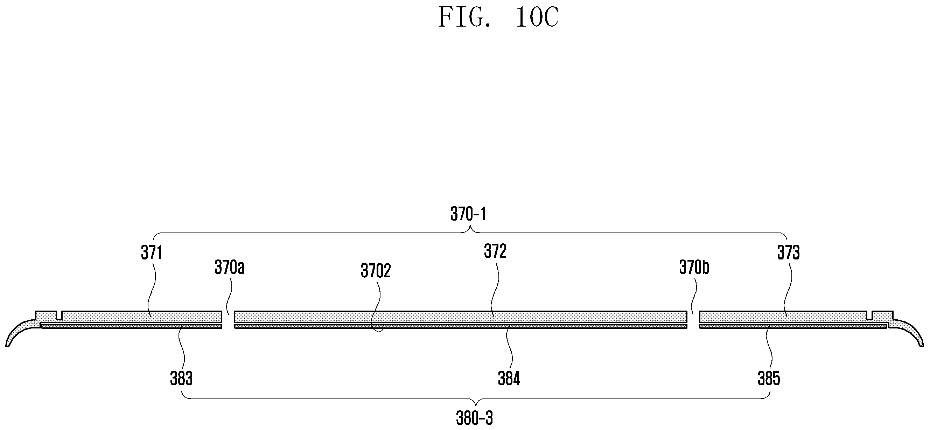

With reference to FIG. 10c, the at least one conductive member 370 may include the first conductive member 371, the second conductive member 372, and the third conductive member 373 divided through the first separation space 370a and the second separation space 370b. In an embodiment, the at least one conductive member 370-1 may include the opening 3702 consecutively formed from the border of the first conductive member 371, along the border of the third conductive member 373 across the second conductive member 372 and configured to at least partially accommodate at least one buffer member 380-3. In an embodiment, the at least one buffer member 380-3 may include a first buffer member 383 provided side by side with the first conductive member 371, a second buffer member 384 provided side by side with the second conductive member 372, and a third buffer member 385 provided side by side with the third conductive member 373. In an embodiment, the first, second, and third buffer members 383, 384, and 385 may have lengths substantially equal to those of the first, second, and third conductive members 371, 372, and 373, and may be provided to be aligned with respect to each other.

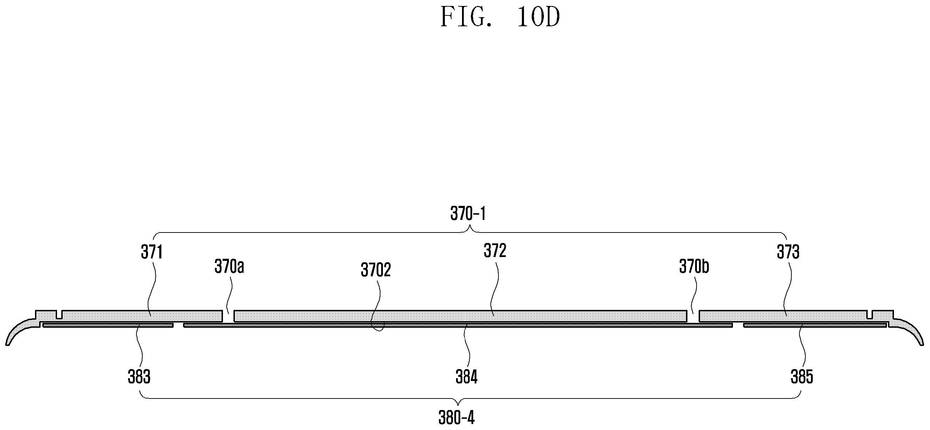

With reference to FIG. 10d, at least one buffer member 380-4 applied to the conductive members 371, 372, and 373 of FIG. 10c may include the first buffer member 383, the second buffer member 384, and the third buffer member 385 spaced apart from each other in the longitudinal direction of the at least one conductive member 370. In an embodiment, the first, second, and third buffer members 383, 384, and 385 may be provided to have lengths different from those of the first, second, and third conductive members 371, 372, and 373. For example, one end of the second buffer member 384 may extend past the first separation space 370a to a portion of the first conductive member 371, and the other end thereof may extend pas the second separation space 370b to a location corresponding to a portion of the third conductive member 373.

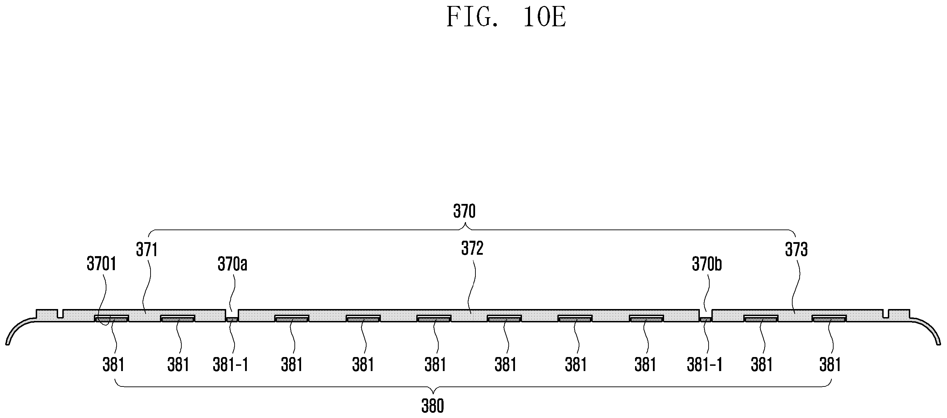

With reference to FIG. 10e, in the constitutionof FIG. 6b, the at least one buffer member 380 may further include additional buffer members 381-1 accommodated in at least a portion of the first separation space 370a and the second separation space 370b.

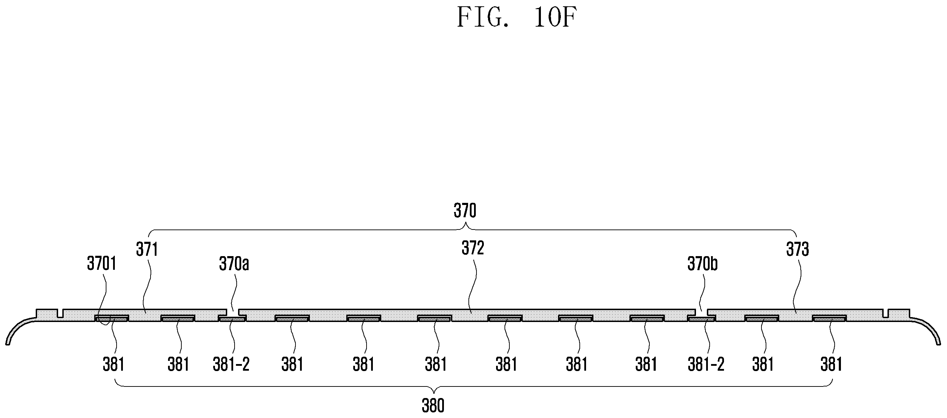

With reference to FIG. 10f, in the constitution of FIG. 10e, the additional buffer members 381-1 may be provided in a way of extending from the separation spaces 370a and 370b to the openings 3701 formed in the surrounding conductive members 371, 372, and 373.

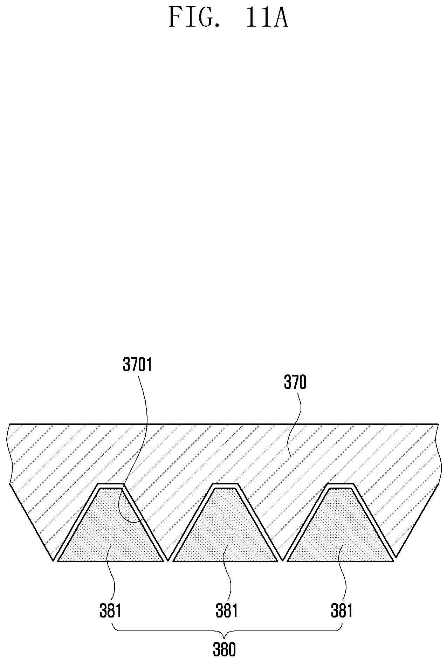

FIGS. 11a to 11f illustrate the layout structure of a conductive member and a buffer member according to various embodiments of the disclosure.

With reference to FIG. 11a, the at least one conductive member 370 may include the plurality of openings 3701 spaced apart from each other along the longitudinal direction. In an embodiment, the at least one buffer member 380 may include the plurality of buffer members 381 at least partially accommodated in the plurality of openings 3701, respectively. In an embodiment, each of the plurality of buffer members 381 may be formed in a substantially triangular shape (e.g., sawtooth shape), and each of the plurality of openings 3701 may also be formed in a shape corresponding thereto.

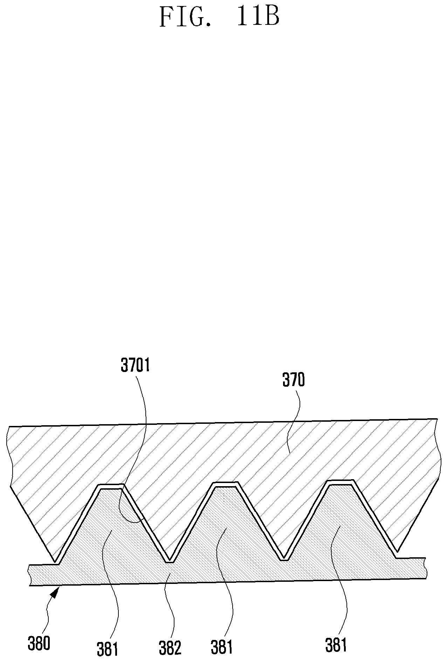

With reference to FIG. 11b, in the constitution of 11a, the at least one buffer member 380 may include the connecting portion 382 that integrally connects the plurality of buffer members 381 (e.g., protruding portions). In this case, the plurality of buffer members 381 may be provided to be accommodated in the plurality of openings 3701, respectively. In an embodiment, the plurality of buffer members 381 and the connecting portion 382 may be provided side by side without overlapping the at least one conductive member 370.

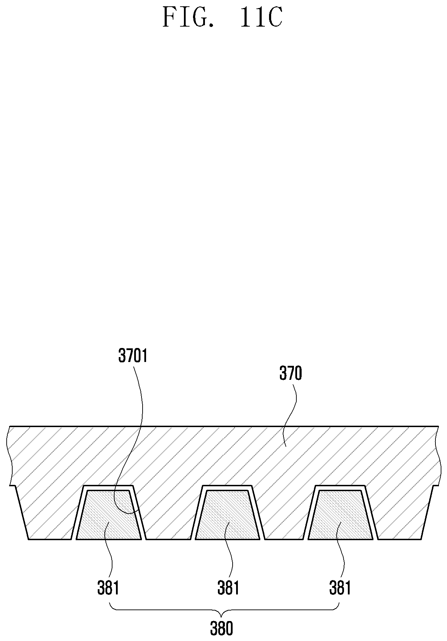

With reference to FIG. 11c, in the constitution substantially identical to that of FIG. 11a, each of the plurality of buffer members 381 may be formed in a trapezoidal shape, and each of the plurality of openings 3701 may be formed in a shape corresponding thereto.

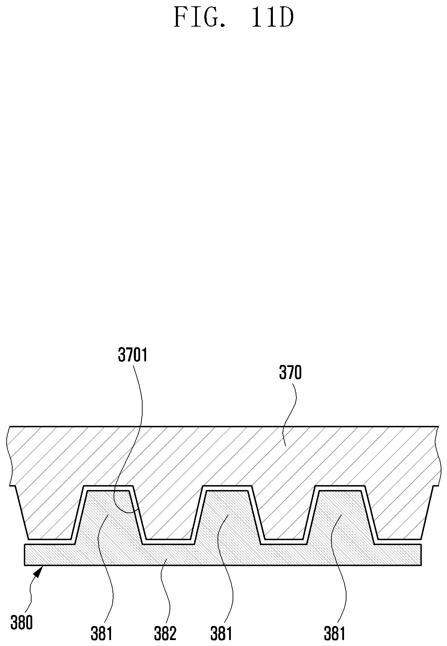

With reference to FIG. 11d, in the constitution of FIG. 11c, the at least one buffer member 380 may include the connecting portion 382 that integrally connects the plurality of buffer members 381 in the trapezoidal shape.

With reference to 11e, in the constitution substantia lly identical to that of FIG. 11a, each of the plurality of buffer members 381 may be formed in an inverted trapezoidal shape, and each of the plurality of openings 3701 may be formed in a shape corresponding thereto.

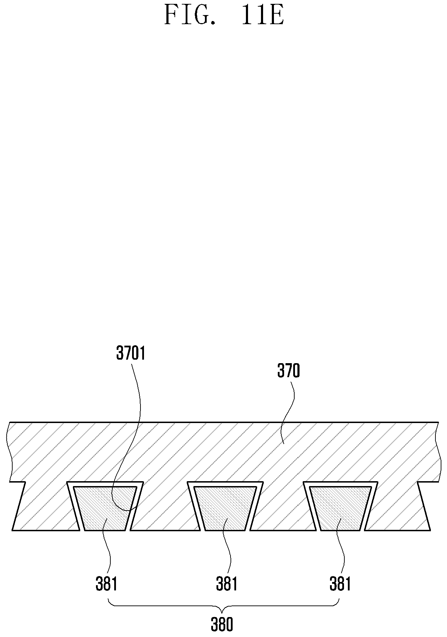

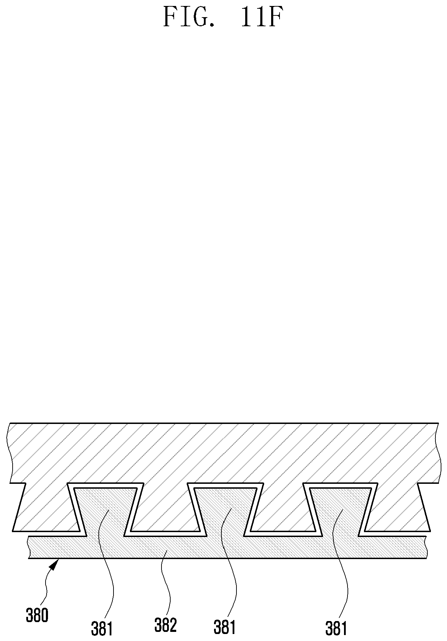

With reference to FIG. 11f, in the constitution of FIG. 11e, the at least one buffer member 380 may include the connecting portion 382 that integrally connects the plurality of buffer members 381 in an inverted trapezoidal shape.

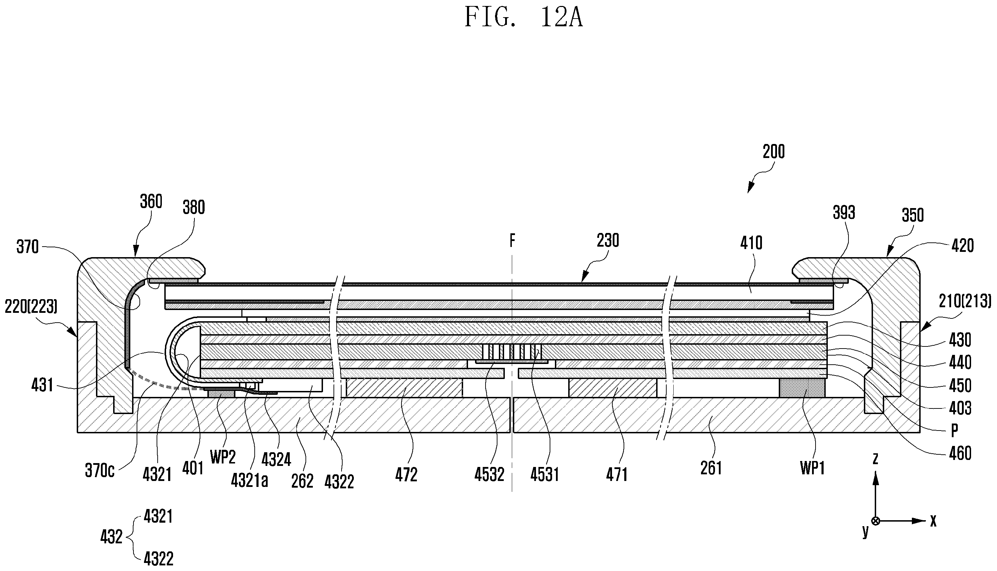

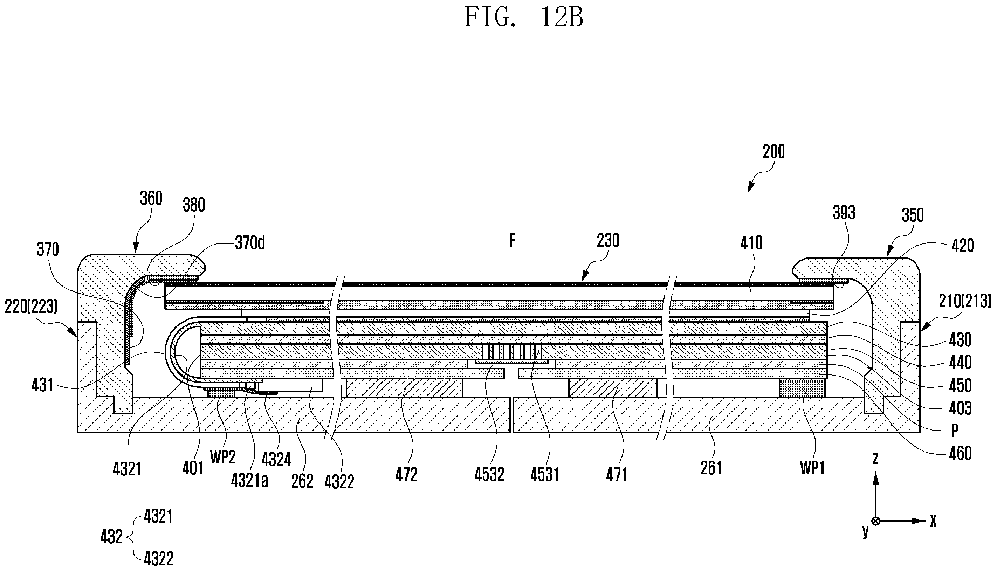

FIGS. 12a and 12b are cross-sectional views of an electronic device including a conductive member and a buffer member according to various embodiments of the disclosure.

In describing the electronic device 200 of FIGS. 12a and 12b, the same reference numerals are assigned to components that are substantially the same as the electronic device 200 of FIG. 7 and detailed description related thereto may be omitted.

With reference to FIG. 12a, the conductive member 370 may be electrically connected to the ground of a substrate (e.g., second substrate 272 of FIG. 3) through an electrical connecting member 370c. In some embodiments, the conductive member 370 may be connected to the surrounding conductive structure (e.g., electrical components connected to metal bracket, ground of display, or ground of substrate) through the electrical connecting member 370c, thereby helping stable induction of static electricity introduced from the outside. In an embodiment, the electrical connecting member 370c may include a flexible printed circuit board (FPCB) or wiring structure such as a cable.

With reference to FIG. 12b, the at least one conductive member 370 and the at least one buffer member 380 provided side by side on the inner surface of the second protective frame 360 without overlapping may include a commonly provided insulating member 370d. In an embodiment, the insulating member 370d may be provided between the at least one conductive member 370 and the flexible display 230 such that static electricity introduced from the outside may be induced to be applied only to the conductive member 370. In an embodiment, the insulating member 370d may include a thin-filmed insulating tape attached to the at least one conductive member 370 and the at least one buffer member 380.

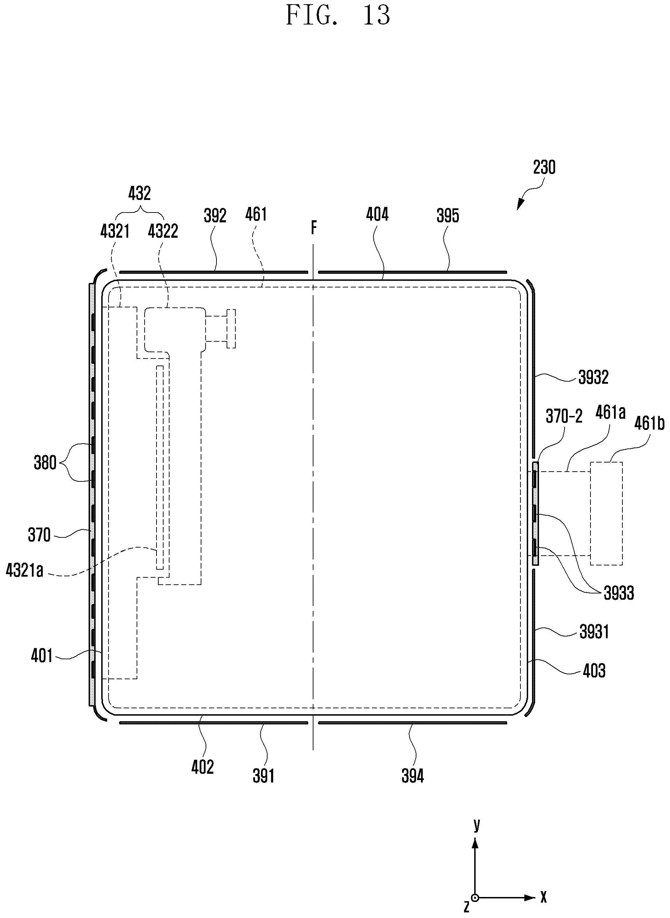

FIG. 13 illustrates the layout structure in which conductive members and buffer members are provided to a flexible display according to various embodiments of the disclosure.

In describing the flexible display 230 of FIG. 13, the same reference numerals are assigned to components that are substantially the same as the flexible display 230 of FIG. 5A and detailed description related thereto may be omitted.

With reference to 13, the electronic device (e.g., electronic device 200 of FIG. 3) may include the digitizer 461 as a lower layer. In an embodiment, the digitizer 461 may include an FPCB 461a including a connector 461b at an end to slide out and to electrically connect to the substrate (e.g., first substrate 271 of FIG. 3) of the electronic device 200. For example, the FPCB 461a may extend outwardly through at least a portion of the third edge 403 of the flexible display 230. In this case, external static electricity may flow into the inside through the FPCB 461a that protrudes more outwardly than the third edge 403 and may damage electric components. In some embodiments, the FPCB 461a may also protrude outward through at least one edge among the first edge 401, the second edge 402, and the fourth edge 404 of the flexible display 230.

According to an exemplary embodiment of the disclosure, when the flexible display 230 is viewed from above, the electronic device 200 may include a conductive member 370-2 including at least one still another opening (e.g., opening 3701 of FIG. 6b) provided in a portion corresponding to the FPCB 461a. In an embodiment, when the flexible display 230 is viewed from above, the electric device 200 may include at least one still another buffer member 3933 that is accommodated in still other openings and provided side by side with the conductive member 370-2, in a portion corresponding to the FPCB 461a. In an embodiment, the constitution of the conductive member 370-2 that includes still other openings and the mutual layout structure of still other buffer members 3933 accommodated in the still other openings may be substantially the same as the layout structure of the at least one conductive member 370 and the at least one buffer member 380 of FIGS. 6a to 6f. In an embodiment, only buffer members 3931 and 3932 may be provided in an area of the third edge 403 in which the FPCB 461a is not slid out. In some embodiments, the digitizer 461 may be replaced with at least one of a touch panel, a fingerprint sensor module, and a display antenna, which is stacked as a component of the flexible display 230 and includes at least one FPCB that slides out from at least one edge.

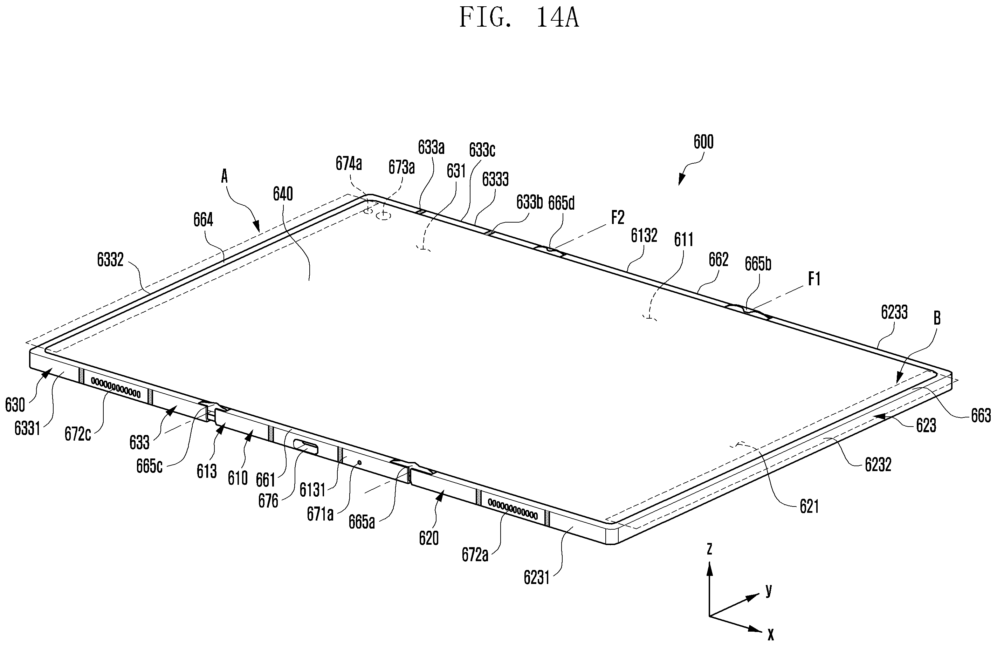

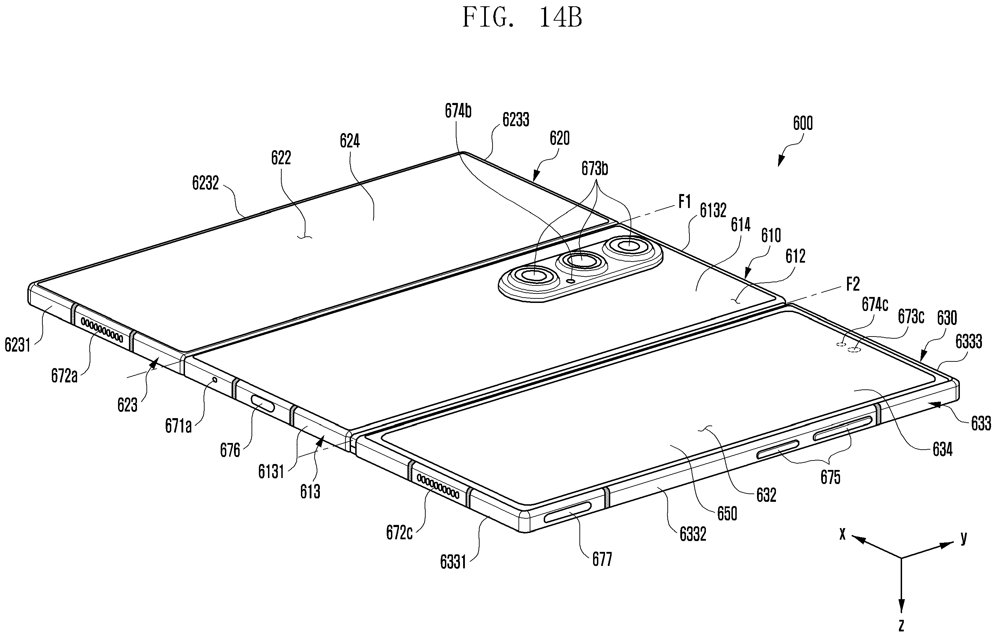

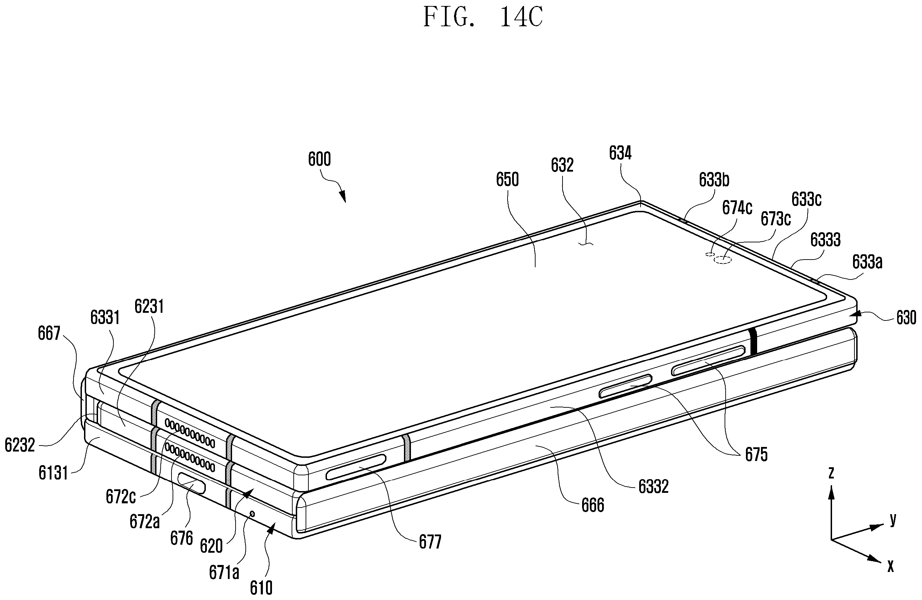

FIG. 14a is a front perspective view of a multi-foldable electronic device in an unfolding state according to various embodiments of the disclosure. FIG. 14b is a rear perspective view of a multi-foldable electronic device in an unfolding state according to various embodiments of the disclosure. FIG. 14c illustrates one surface of a multi-foldable electronic device in a folding state according to various embodiments of the disclosure.

With reference to FIGS. 14a to 14c, a multi-foldable electronic device 600 (e.g., portable communication device or electronic device) may include a first housing 610, a second housing 620 rotatably connected to the first housing 610 based on a first folding axis (F1) through a first hinge device (not shown) in one (e.g., right) direction (e.g., x -axis direction) of the first housing 610, and a third housing 630 (e.g., third housing portion) rotatably connected to the first housing 610 based on a second folding axis (F2) through a second hinge device (not shown) in the other (e.g., left) direction (e.g., -x -axis direction) of the first housing 610. In an embodiment, the multi-foldable electronic device 600 may include a flexible display 640 (e.g., flexible display 230 of FIG. 1a) (e.g., first display) provided to be supported by the first housing 610, the second housing 620, and the third housing 630. In an embodiment, the multi-foldable electronic device 600 may include a sub display 650 (e.g., second display) provided through the third housing 630.

According to various embodiments, the first housing 610 may include a first surface 611, a second surface 612 that faces in the opposite direction to the first surface 611, and a first lateral member 613 that surrounds a first space between the first surface 611 and the second surface 612. In an embodiment, at least a portion of the first lateral member 613 may form at least a portion of the side surface of the multi-foldable electronic device 600. In an embodiment, the first lateral member 613 may include a first side surface 6131 and a second side surface 6132 provided at a location opposite to the first side surface 6131. In an embodiment, the first housing 610 may include a first rear cover 614 coupled to the first lateral member 613. In an embodiment, the first space may be formed through the first rear cover 614 coupled to the first lateral member 613 on the second surface 612 of the first housing 610. According to various embodiments, the second housing 620 may include a third surface 621, a fourth surface 622 that faces the opposite direction to the third surface 621, and a second lateral member 623 that surrounds a second space between the third surface 621 and the fourth surface 622. In an embodiment, at least a portion of the second lateral member 623 may form at least a portion of the side surface of the multi-foldable electronic device 600. In an embodiment, the second lateral member 623 may include a third side surface 6231, a fourth side surface 6232 that extends in a direction perpendicular to the third side surface 6231, and a fifth side surface 6233 that extends from the fourth side surface 6232 and is parallel to the third side surface 6231. In an embodiment, the second housing 620 may include a second rear cover 624 coupled to the second lateral member 623. In an embodiment, the second space may be formed through the second rear cover 624 coupled to the second lateral member 623 on the fourth surface 622.

According to various embodiments, the third housing 630 may include a fifth surface 631, a sixth surface 632 that faces the opposite direction to the fifth surface 631, and a third lateral member 633 that surrounds a third space between the fifth surface 631 and the sixth surface 632. In an embodiment, at least a portion of the third lateral member 633 may form at least a portion of the side surface of the multi-foldable electronic device 600. In an embodiment, the third lateral member 633 may include a sixth side surface 6331, a seventh side surface 6332 that extends in a direction perpendicular to the sixth side surface 6331, and an eighth side surface 6333 that extends from the seventh side surface 6332 and is parallel to the sixth side surface 6331. In an embodiment, the third space may be formed through a third rear cover 634 coupled to the third lateral member 633 on the sixth side surface 6331.

According to various embodiments, the multi-foldable electronic device 600 may be configured such that, in an unfolding state (e.g., first state), the first housing 610, the second housing 620, and the third housing 630 are positioned side by side, and accordingly, the first surface 611, the third surface 621, and the fifth surface 631 face the same direction. In an embodiment, the multi-foldable electronic device 600 may be configured such that, in a folding state (e.g., second state), the first housing 610, the second housing 620, and the third housing 630 are sequentially stacked and accordingly, the first surface 611 and the third surface 621 face each other, and the fourth surface 622 and the fifth surface 631 face each other. In this case, the second surface 612 and the sixth surface 632 may be positioned to be visible from the outside, and the third surface 621 and the fourth surface 622 may be positioned to not be visible from the outside through the first housing 610 and the third housing 630. In an embodiment, the sub display 650 may be provided to be visible from the outside through at least a portion of the sixth surface 632 in the unfolding state and/or folding state.

According to various embodiments, the multi-foldable electronic device 600 may include a first protective frame 661 (e.g., first decorative member) provided to the first housing 610 and provided to cover edges of the flexible display 640 and a second protective frame 662 (e.g., second decorative member). In an embodiment, the first protective frame 661 may be provided along the first side surface 6131 in the first housing 610, and the second protective frame 662 may be provided along the second side surface 6132. In an embodiment, edges of the flexible display 640 corresponding to the first housing 610 may be concealed to not be visible from the outside through the first and second protective frames 661 and 662.

According to various embodiments, the multi-foldable electronic device 600 may include a third protective frame 663 (e.g., third decorative member) provided to the second housing 620 and provided to cover the edges of the flexible display 640. In an embodiment, the third protective frame 663 may be provided along the third side surface 6231, the fourth side surface 6232, and the fifth side surface 6233 in the second housing 620. In an embodiment, edges of the flexible display 640 corresponding to the second housing 620 may be concealed to not be visible from the outside through the third protective frame 663. In an embodiment, the multi-foldable electronic device 600 may include a fourth protective frame 664 (e.g., fourth decorative member) provided to the third housing 630 and provided to cover the edges of the flexible display 640. In an embodiment, the fourth protective frame 664 may be provided along the sixth side surface 6331, the seventh side surface 6332, and the eighth side surface 6333 in the third housing 630. In an embodiment, edges of the flexible display 640 corresponding to the third housing 630 may be concealed to not be visible from the outside through the fourth protective frame 664.

According to various embodiments, the multi-foldable electronic device 600 may include a first protective cap 665a provided between the first protective frame 661 and the third protective frame 663 and provided to cover at least a portion of the edge of the flexible display 640 and a second protective cap 665b provided between the second protective frame 662 and the third protective frame 663 and provided to cover at least a portion of the edge of the flexible display 640. In an embodiment, the multi-foldable electronic device 600 may include a third protective cap 665c provided between the first protective frame 661 and the fourth protective frame 664 and provided to cover at least a portion of the edge of the flexible display 640, and a fourth protective cap 665d provided between the second protective frame 662 and the fourth protective frame 664 and provided to cover at least a portion of the edge of the flexible display 640. In an embodiment, at least one protective cap among the first, second, third, and fourth protective caps 665a, 665b, 665c, and 665d may be omitted.

According to various embodiments, the multi-foldable electronic device 600 may include at least one electronic component provided to at least one of the first housing 610, the second housing 620 and/or the third housing 630. In an embodiment, the at least one electronic component may include the flexible display 640 (e.g., first display) provided through the first housing 610, the second housing 620, and the third housing 630, the sub display 650 (e.g., second display) provided to the third housing 630, at least one microphone 671a, 671b (e.g., input module or input device), at least one speaker 672a, 672b, 672c, 672d (e.g., audio output module or audio output device), at least one camera 673a, 673b, 673c (e.g., camera module or camera device), at least one sensor 674a, 674b, 674c (e.g., sensor module), at least one key button 675 (e.g., input device or physical key), a connector port 676, or a socket device 677. In some embodiments, the electronic device 600 may additionally include at least one other component. In some embodiments, at least one component among the above-described components may be omitted.

According to various embodiments, the flexible display 640 may be provided in a receiving space formed by the housings 610, 620, and 630. For example, the flexible display 640 may be provided in a recess formed by the housings 610, 620, and 630, and may be provided to occupy substantially most of the front surface of the electronic device 600 in the unfolding state. In an embodiment, the sub display 650 may be provided to be visible from the outside through the third rear cover 634 in the third housing 630.

In various embodiments, the at least one microphone 671a, 671b may include the first microphone 671a provided through the first side surface 6131 of the first housing 610 and the second microphone 671b provided through the second side surface 6132 of the first housing 610. In some embodiments, the at least one microphone 671a, 671b may be provided on the third side surface 6231 and/or the fifth side surface 6233 of the second housing 620. In some embodiments, the at least one microphone 671a, 671b may also be provided on the sixth side surface 6331 and/or the eighth side surface 6333 of the third housing 630.

In various embodiments, the at least one speaker 672a, 672c may include the first speaker 672a provided to output sound through the third side surface 6231 of the second housing 620 and the second speaker 672c provided to output sound through the sixth side surface 6331 of the third housing 630. In an embodiment, the at least one speaker 672a, 672c may be symmetrically provided to implement stereophonic sound (e.g., three-dimensional sound) in the unfolding state or the folding state of the multi-foldable electronic device 200.

According to various embodiments, the at least one camera 673a, 673b, 673c may include the first camera 673a provided in the third space of the third housing 630 and provided through the fifth surface 631 of the third housing 630, the second camera 673b provided through the second surface 612 of the first housing 610, and/or the third camera 673c provided through the sixth surface 632 of the third housing 630. In an embodiment, the at least one camera 673a, 673b, 673c may include one or a plurality of lenses, an image sensor, and/or an image signal processor. In some embodiments, the at least one camera 673a, 673b, 673c may include two or more lenses (e.g., wide-angle and/or telephoto lenses) and image sensors, and may be provided together on one surface of one of the first housing 610, the second housing 620, and the third housing 630.

According to various embodiments, the at least one sensor 674a, 674b, 674c may generate an electrical signal or a data value corresponding to an internal operating state of the multi-foldable electronic device 600 or an external environmental state. In an embodiment, the at least one sensor 674a, 674b, 674c may include the first sensor 674a provided on the fifth surface 631 of the third housing 630, the second sensor 674b provided on the second surface 612 of the first housing 610, and/or the third sensor 674c provided on the sixth surface 632 of the third housing 630. In some embodiments, the at least one sensor 674a, 674b, 674c may include at least one of a gesture sensor, a grip sensor, a color sensor, an infrared (IR) sensor, a light sensor, an ultrasonic sensor, an iris recognition sensor, a distance detection sensor (e.g., time of flight (TOF) sensor or light detection and ranging (LiDAR) sensor).

According to various embodiments, the at least one key button 675 may be provided to the seventh side surface 6332 of the third housing 630. This may help improve use convenience by providing the sixth surface 632 to face upward to use the sub display 650 and at least one key button 675 to be positioned on the right side when the multi-foldable electronic device 600 is in the folding state. In some embodiments, the at least one key button 675 may be provided on at least one side surface of the first side surface 6131 or the second side surface 6132 of the first housing 610, the third side surface 6231 or the fifth side surface 6233 of the second housing 620, and/or the sixth side surface 6331 or the eighth side surface 6333 of the third housing 630, which may be used even when the multi-foldable electronic device 600 is in the unfolding state and/or the folding state.

According to various embodiments, the connector port 676 may be provided through the first side surface 6131 of the first housing 610. In an embodiment, the connector port 676 may include a connector (e.g., USB connector or IF module (interface connector port module)) structure for transmitting and receiving power and/or data with an external electronic device. In some embodiments, the connector port 676 may also be provided on at least one side surface of the second side surface 6132 of the first housing 610, the third side surface 6231, the fourth side surface, 6232 or the fifth side surface 6233 of the second housing 620, and/or the sixth side surface 6331, the seventh side surface 6332, or the eighth side surface 6333 of the third housing 630 when the multi-foldable electronic device 600 is in the unfolding state and/or folding state.

According to various embodiments, the socket device 677 may be provided on the seventh side surface 6332 of the third housing 630 such that the multi-foldable electronic device 600 may be used even in the folding state. In an embodiment, the socket device 677 may include a tray coupled to be retractable from the seventh side surface 6332 to accommodate a SIM card or an external memory card.

According to various embodiments, at least one of the at least one microphone 671a, 671b, the at least one speaker 672a, 672c, the at least one key button 675, the connector port 676, and the socket device 677 may be exposed to an external environment through at least one hole (e.g., through hole) formed in the first housing 610, the second housing 620, and/or the third housing 630.

According to various embodiments, the multi-foldable electronic device 600 may include a bending portion (e.g., bending portion 432 of FIG. 7) that extends outward from the flexible display 640 and folds toward the rear surface of the flexible display 640 through an area (area A) corresponding to the seventh side surface 6332 parallel to the second folding axis (F2). In this case, static electricity flowing in between the fourth protective frame 664 and the flexible display 640 provided at a location corresponding to the seventh side surface 6332 may damage an internal electrical component along the bending portion (e.g., bending portion 432 of FIG. 7).

According to an exemplary embodiment of the disclosure, the multi-foldable electronic device 600 may include at least one conductive member (e.g., conductive member 370 of FIG. 7) and at least one buffer member (e.g., buffer member 380 of FIG. 7) that are provided side by side without overlapping each other, between the fourth protective frame 664 and the flexible display 640, at a location corresponding to the seventh side surface 6332. The layout structure of the at least one conductive member and the at least one buffer member may be substantially the same as the layout structure of the at least one conductive member 370 and the at least one buffer member 380 of FIGS. 6a to 6f. In some embodiments, the multi-foldable electronic device 600 may include still another bending portion (e.g., bending portion 432 of FIG. 7) that protrudes outward from the edge of the flexible display 640 and folds toward the rear surface of the flexible display 640, in an area (area B) corresponding to the fourth side surface 6232. In this case, the multi-foldable electronic device 600 may further include at least one conductive member (e.g., conductive member 370 of FIG. 7) and at least one buffer member (e.g., buffer member 380 of FIG. 7) that are provided side by side without overlapping each other between the third protective frame 663 and the flexible display 640, at a location corresponding to the fourth side surface 6232. In an embodiment, the parallel layout structure of the at least one conductive member and the at least one buffer member may help reduce the thickness of the electronic device 600 in the z -axis direction, and effective electrostatic induction through the at least one conductive member and buffering operation and sealing operation through the at least one buffer member may be induced.

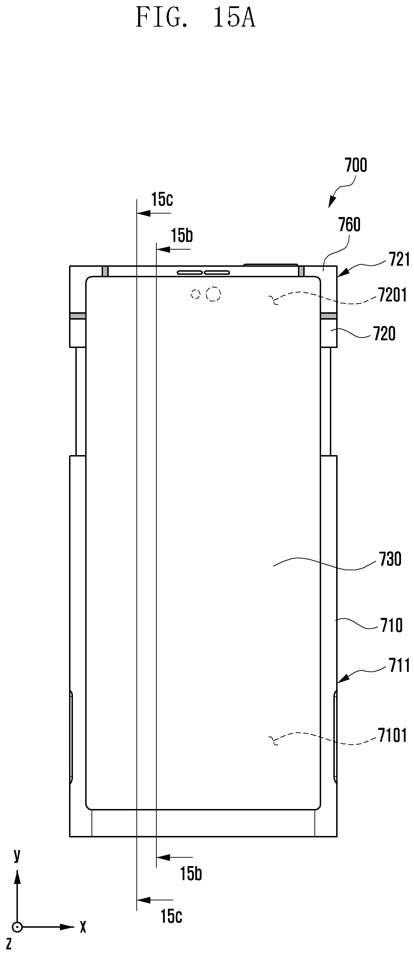

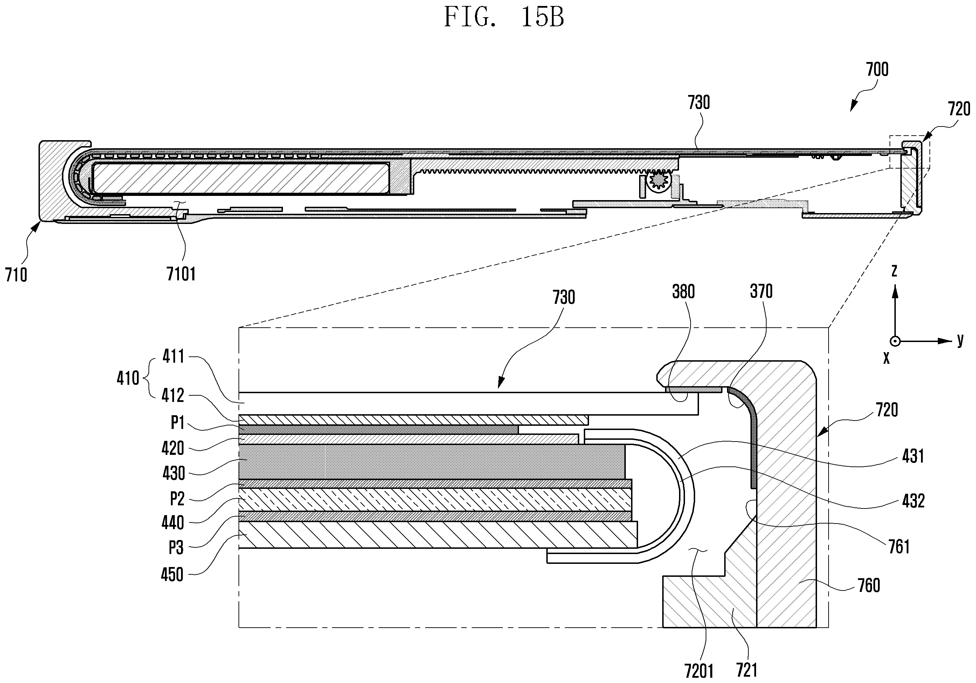

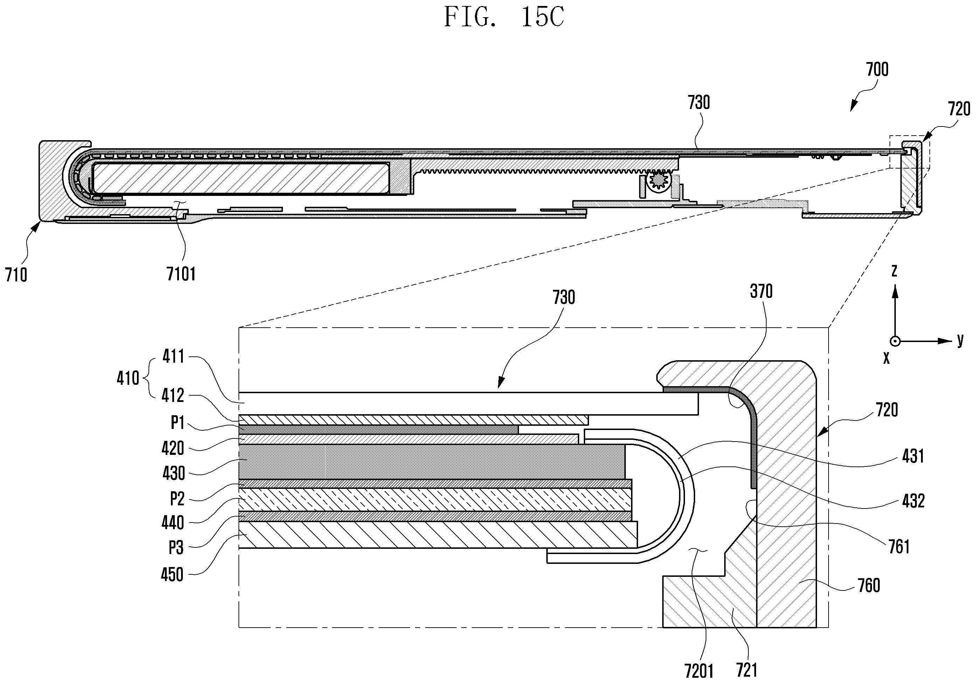

FIG. 15a is a top view of an electronic device in a slide-out state according to various embodiments of the disclosure. FIG. 15b is a cross-sectional view of an electronic device viewed along line 15b-15b of FIG. 15a according to various embodiments of the disclosure. FIG. 15c is a cross-sectional view of an electronic device viewed along line 15c-15c of FIG. 15a according to various embodiments of the disclosure.

For example, FIG. 15b is a cross-sectional view of an electronic device 700 illustrating a portion in which the conductive member 370 (e.g., conductive member 370 of FIG. 6b) and the buffer member 380 (e.g., buffer member 380 of FIG. 6b) accommodated in the opening (e.g., opening 3701 of FIG. 6b) of the conductive member 370 are provided side by side on the inner surface of the second housing 720.

For example, FIG. 15c is a cross-sectional view of the electronic device 700 illustrating a state in which only the conductive member 370 (e.g., conductive member 370 of FIG. 6b) is provided in a portion in which the opening (e.g., opening 3701 of FIG. 6b) is absent.

With reference to FIGS. 15a to 15c, the electronic device 700 (e.g., slidable electronic device or rollable electronic device) may include a first housing 710 that includes a first lateral member 711 and a second housing 720 that slidably couples in a specified direction and specified round distance from the first housing 710 and includes a second lateral member 721. In an embodiment, the electronic device 700 may include a flexible display 730 that is fixed to at least a portion of the second housing 720 and of which a display area is variable by sliding in or sliding out from an internal space 7101 of the first housing 710 according to a sliding operation of the second housing 720. For example, the flexible display 730 may have a first display area in a state in which the second housing 720 is slid out from the first housing 710 in a first direction (e.g., y-axis direction). In an embodiment, the flexible display 730 may have a second display area less than the first display area in a state in which the second housing 720 is slid in in a second direction (e.g., -y-axis direction) opposite to the first direction.

According to various embodiments, the flexible display 730 may have the stacking structure substantially the same as the flexible display 230 of FIG. 7. In an embodiment, the flexible display 730 may include the display panel 430, the POL 420 stacked on the top surface of the display panel 430, the protective layer 410 (e.g., window layer), the polymer layer 440 stacked on the rear surface of the display panel 430 and/or the support plate 450. In an embodiment, the flexible display 730 may include the bending portion 432 and the protective layer 431 provided in a way of extending from the display panel 430 and folding toward the rear surface of the support plate 450. In an embodiment, the flexible display 730 may include a control circuit (e.g., display IC (DDI)) (not shown) provided to the bending portion 432.

According to various embodiments, the electronic device 700 may include a protective frame 760 that covers the edge of the flexible display 730 to not be visible from the outside along the border of the second housing 720. In an embodiment, the protective frame 760 may be fixed to the second lateral member 721 of the second housing 720. In an embodiment, the electronic device 700 may include the at least one conductive member 370 provided between the inner surface 761 of the protective frame 760 and the flexible display 730 and the at least one buffer member 380 provided side by side with the at least one conductive member 370. In an embodiment, the layout structure of the at least one conductive member 370 and the at least one buffer member 380 may be substantially the same as the layout structure of the at least one conductive member 370 and the at least one buffer member 380 of FIGS. 6a to 6f. In an embodiment, the parallel layout structure of the at least one conductive member 370 and the at least one buffer member 380 may help reduce the thickness of the electronic device 700 in the z -axis direction, and effective electrostatic induction through the at least one conductive member 370 and buffering operation and sealing operation through the at least one buffer member 380 may be induced.

According to various embodiments, an electronic device (e.g., electronic device 200 of FIG. 7) includes a first housing (e.g., first housing 210 of FIG. 7), a second housing (e.g., second housing 220 of FIG. 7) rotatably coupled to the first housing based on a folding axis (e.g., folding axis (F) of FIG. 7) through a hinge device (e.g., hinge device 320. of FIG. 3), a flexible display (e.g., flexible display 230 of FIG. 7), comprising a display panel 430, provided to be supported by the first housing and the second housing, and including a bending portion that extends from at least a portion of a first edge (e.g., first edge 401 of FIG. 7) of the display panel 430 parallel to the folding axis and folds toward the back surface of the flexible display 230, a first protective frame (e.g., first protective frame 350 of FIG. 7) provided to the first housing to cover edges of the flexible display (e.g., portion of second edge 402, third edge 403, and portion of fourth edge 404 of FIG. 6a) to not be visible from the outside, a second protective frame (e.g., second protective frame 360 of FIG. 7) provided to the second housing to cover edges of the flexible display (e.g., first edge 401, portion of second edge 402, and fourth edge 404 of FIG. 6a) to not be visible from the outside, and including a first area corresponding to the bending portion and a second area other than the first area, at least one conductive member (e.g., conductive member 370 of FIG. 7) provided on the inner surface of the second protective frame, corresponding to the first area, and at least one buffer member (e.g., buffer member 380 of FIG. 7) provided on the inner surface of the second protective frame, corresponding to the first area and the second area, and, in the first area, when the flexible display is viewed from above, the at least one conductive member and the at least one buffer member are at least partially provided side by side, and between the second protective frame and the flexible display, static electricity introduced through the first edge is induced to the at least one conductive member.

According to various embodiments, the flexible display may include a control circuit (e.g., control circuit 4321a of FIG. 5a) provided to the bending portion.

According to various embodiments, when the flexible display is viewed from above, the at least one buffer member may be provided to not overlap the at least one conductive member.

According to various embodiments, when the flexible display is viewed from above, the at least one buffer member may be provided at a location that at least partially overlaps the flexible display.

According to various embodiments, when the flexible display is viewed from above, the at least one conductive member may be provided at a location that at least partially overlaps the flexible display.

According to various embodiments, the at least one conductive member may include a plurality of openings (e.g., openings 3701 of FIG. 6b) provided at specific intervals along the first direction, the at least one buffer member may include a plurality of buffer members (e.g., buffer members 381 of FIG. 6b) provided to be accommodated in the plurality of openings, respectively, and attached to the inner surface of the second protective frame.

According to various embodiments, the thickness (e.g., first thickness (t1) of FIG. 6f) of the at least one buffer member may be formed to be equal to or thicker than the thickness (e.g., second thickness (t2) of FIG. 6f) of the at least one conductive member.

According to various embodiments, the at least one buffer member may be provided in a way of contacting the top surface of the flexible display.

According to various embodiments, the at least one conductive member may include a plurality of openings provided at specific intervals along the first direction, the at least one buffer member (e.g., buffer member 380-1 of FIG. 10a) may include a connecting portion (e.g., connecting portion 382 of FIG. 10a) having the length along the first direction and a plurality of protruding portions (e.g., protruding portions 381 of FIG. 10a) protruding from the connecting portion at specific intervals, and the at least one buffer member may be provided in such a manner that the plurality of protruding portions are accommodated through the plurality of openings, respectively, and attached to the inner surface (e.g., inner surface 361 of FIG. 6c) of the second protective frame.

According to various embodiments, when the flexible display is viewed from above, the connecting portion may be provided to not overlap the at least one conductive member.

According to various embodiments, when the flexible display is viewed from above, the connecting portion may be provided to overlap the at least one conductive member.

According to various embodiments, the inner surface (e.g., inner surface 361 of FIG. 6c) of the second protective frame may include a first flat portion (e.g., first flat portion 3611 of FIG. 6c) provided in a direction parallel to the top surface of the flexible display, a second flat portion (e.g., second flat portion 3612 of FIG. 6c) provided in a direction perpendicular to the top surface of the flexible display, and a curved portion (e.g., curved portion 3613 of FIG. 6c) connecting the first flat portion and the second flat portion, and the at least one conductive member may be provided from at least a portion of the first flat portion to at least a portion of the curved portion.

According to various embodiments, the at least one buffer member may be provided to at least a portion of the first flat portion.

According to various embodiments, the electronic device may further include an insulating member (e.g., insulating member 370d of FIG. 12b) provided to cover at least a portion of the at least one conductive member and the at least one buffer member.

According to various embodiments, the second housing may include at least two conductive portions (e.g., first, second, and third conductive portions 2231, 2232, and 2233 of FIG. 8) that are electromagnetically separated through at least one non-conductive portion (e.g., first and second non-conductive portions 2234 and 2235 of FIG. 8), and the at least one conductive member may be separately provided to not be provided at a location corresponding to the non-conductive portion.

According to various embodiments, the at least one buffer member (e.g., buffer member 381-1 of FIG. 10a) may be provided at a location corresponding to the non-conductive portion.

According to various embodiments, the at least two conductive portions may be used as an antenna configured to transmit and/or receive a wireless signal in at least one frequency band.

According to various embodiments, when the flexible display is viewed from above, the at least one conductive member and the at least one buffer member may be provided at a location that at least partially overlaps the first edge.

According to various embodiments, the electronic device may include a flexible printed circuit board (FPCB) (e.g., FPCB 461a of FIG. 13) that extends from a lower layer and is connected to a substrate provided to the electronic device through the lower layer (e.g., lower layer 460 of FIG. 4) provided below the display panel and a second edge (e.g., third edge 403 of FIG. 13) different from the first edge, a conductive member (e.g., conductive member 370-2 of FIG. 13) that includes at least one still another opening provided to a portion corresponding to the FPCB when the flexible display is viewed from above, and at least one still another buffer member (e.g., buffer member 3933 of FIG. 13) that is accommodated in the still other openings and provided side by side with the conductive member in the portion corresponding to the FPCB, when the flexible display is viewed from above.

According to various embodiments, the lower layer may include a digitizer (e.g., digitizer 461 of FIG. 13).

The embodiments of the disclosure disclosed in the present specification and drawings are only specific examples to easily explain technical contents according to the embodiments of the disclosure and to help understanding of embodiments of the disclosure and are not construed to limit the scope of the embodiments of the disclosure. Therefore, the scope of various embodiments of the disclosure should be interpreted as including all changes and modifications derived based on the technical spirit of various embodiments of the disclosure in addition to the embodiments disclosed herein.

## Claims

1. An electronic device comprising:
a first housing (210);
a second housing (220) rotatably coupled to the first housing (210) based on a folding axis (F) through a hinge device (320);
a flexible display (230) provided to be supported by the first housing (210) and the second housing (220), and including a bending portion (432) that extends from at least a portion of a first edge (401) parallel to the folding axis (F) and folds toward the back surface of the flexible display 230;
a first protective frame (350) provided to the first housing (210) to cover edges (402, 403, 404) of the flexible display (230) to not be visible from the outside;
a second protective frame (360) provided to the second housing (220) to cover edges (401, 402, 404) of the flexible display (230) to not be visible from the outside, and including a first area corresponding to the bending portion (432) and a second area other than the first area;
at least one conductive member (370) provided on the inner surface (361) of the second protective frame (360), corresponding to the first area; and
at least one buffer member (380) provided between the inner surface (361) of the second protective frame (360) and the flexible display (230) and corresponding to the first area and the second area,
wherein, in the first area, when the flexible display (230) is viewed from above, the at least one conductive member (370) and the at least one buffer member (380) are at least partially provided side by side, and
between the second protective frame (360) and the flexible display (230), static electricity introduced through the first edge (401) is induced to the at least one conductive member (370).

2. The electronic device of claim 1, wherein the flexible display (230) includes a control circuit (4321a) provided to the bending portion (432).

3. The electronic device of claim 1 or 2, wherein, when the flexible display (230) is viewed from above, the at least one buffer member (380) is provided to not overlap the at least one conductive member (370).

4. The electronic device of any one of claims 1 to 3, wherein, when the flexible display (230) is viewed from above, the at least one buffer member (380) is provided at a location that at least partially overlaps the flexible display (230).

5. The electronic device of any one of claims 1 to 4, wherein, when the flexible display (230) is viewed from above, the at least one conductive member (370) is provided at a location that at least partially overlaps the flexible display (230).

6. The electronic device of any one of claims 1 to 5, wherein:
the at least one conductive member (370) includes a plurality of openings (3701) provided at specific intervals along the first direction, and
the at least one buffer member (380) includes a plurality of buffer members (381) to be accommodated in the plurality of openings (3701), respectively, and attached to the inner surface (361) of the second protective frame (360).

7. The electronic device of any one of claims 1 to 6, wherein the thickness (t1) of the at least one buffer member (380) is formed to be equal to or thicker than the thickness (t2) of the at least one conductive member (370).

8. The electronic device of claim 7, wherein the at least one buffer member (380) is provided in a way of contacting the top surface of the flexible display (230).

9. The electronic device of any one of claims 1 to 7, wherein:
the at least one conductive member (370) includes a plurality of openings provided at specific intervals along the first direction,
the at least one buffer member (380-1) includes a connecting portion (382) having the length along the first direction and a plurality of protruding portions (381) protruding from the connecting portion (382) at specific intervals, and
the at least one buffer member (380-1) is provided in such a manner that the plurality of protruding portions (381) are accommodated through the plurality of openings, respectively, and attached to the inner surface (361) of the second protective frame (360).

10. The electronic device of claim 9, wherein, when the flexible display (230) is viewed from above, the connecting portion (382) is provided to not overlap the at least one conductive member (370).

11. The electronic device of claim 9, wherein, when the flexible display (230) is viewed from above, the connecting portion (382) is provided to overlap the at least one conductive member (370).

12. The electronic device of any one of claims 1 to 11, wherein:
the inner surface (361) of the second protective frame (360) includes:
a first flat portion (3611) provided in a direction parallel to the top surface of the flexible display (230);
a second flat portion (3612) provided in a direction perpendicular to the top surface of the flexible display (230); and
a curved portion (3613) connecting the first flat portion (3611) and the second flat portion (3612), and
the at least one conductive member (370) is provided from at least a portion of the first flat portion (3611) to at least a portion of the curved portion (3613).

13. The electronic device of claim 12, wherein the at least one buffer member (380) is provided to at least a portion of the first flat portion (3611).

14. The electronic device of any one of claims 1 to 13, further comprising:
an insulating member (370d) provided to cover at least a portion of the at least one conductive member (370) and the at least one buffer member (380).

15. The electronic device of any one of claim 1 to 14, wherein:
the second housing (220) includes at least two conductive portions (2231, 2232, 2233) that are electromagnetically separated through at least one non-conductive portion (2234, 2235),
the at least one conductive member (370) is separately provided to not be provided at a location corresponding to the non-conductive portion.
